# EUROPÄISCHE PATENTSCHRIFT

(11) **EP 2 160 263 B1**
(45) Veröffentlichungstag und Bekanntmachung des Hinweises auf die Patenterteilung: **26.11.2014**
(21) Anmeldenummer: 08749407.6
(22) Anmeldetag: 08.05.2008
(51) Int. Cl.: B23K 1/00

(54) **REFLOW-LÖTANLAGE MIT AN EXTERNE TRANSPORTGESCHWINDIGKEITEN ANPASSBAREM TEMPERATURPROFIL**
REFLOW SOLDERING SYSTEM WITH A TEMPERATURE PROFILE WHICH CAN BE ADAPTED TO EXTERNAL TRANSPORT SPEEDS
INSTALLATION DE SOUDAGE PAR REFUSION COMPRENANT UN PROFIL DE TEMPÉRATURE POUVANT ÊTRE ADAPTÉ À DES VITESSES DE TRANSPORT EXTERNES

(30) Priorität: 26.06.2007 DE 102007029441
(43) Veröffentlichungstag der Anmeldung: 10.03.2010
(73) Patentinhaber: Rehm Thermal Systems GmbH, 89143 Blaubeuren-Seissen (DE)
(72) Erfinder: REHM, Johannes, 89143 Blaubeuren-Seissen (DE)
(74) Vertreter: Grünecker, Kinkeldey, Stockmair & Schwanhäusser
(86) Internationale Anmeldenummer: PCT/EP2008/003719
(87) Internationale Veröffentlichungsnummer: WO 2009/000364

(56) Entgegenhaltungen:
- DE-A-102005 018 539
- JP-A- 09 206 932
- US-A- 6 152 353

## Beschreibung

Die vorliegende Erfindung betrifft Reflow-Lötanlagen und damit aufgebaute Systeme und Verfahren, in denen Substrate mit einer Lotpaste bedruckt, mit entsprechenden Komponenten bestückt und anschließend durch ein Aufschmelzlötverfahren elektrisch und thermisch mit dem Substrat verbunden werden, wobei die Transportgeschwindigkeit bei der Zufuhr der Substrate zur Lötanlage vorgegeben ist.
Eine solche Reflow-Lötanage, ein solches System und ein solches verfahren sind in DE 102 005 539 A1 beschrieben.

Das Löten mittels eines Reflow-Verfahrens bzw. Aufschmelzverfahrens beschreibt eine Technik, in der elektrisch und thermisch leitfähige Verbindungen zwischen einem Substratträger, etwa einer Leiterplatte, und entsprechenden Bauelemente, etwa elektronischen Komponenten, durch Aufschmelzen einer Lotpaste hergestellt werden. Die Lotpaste weist dabei eine entsprechende Zusammensetzung auf, um die geeigneten elektrischen, thermischen und mechanischen Eigenschaften der entsprechenden Verbindungsstellen zu ermöglichen. Beispielsweise werden Verbindungen mit 96,5 % Zinn, 3 % Silber und 0,5 % Kupfer eingesetzt, wobei auch andere Zusammensetzungen Verwendung finden. Zur Herstellung der Verbindung wird das Substrat bzw. die Leiterplatte zunächst mit Lotpaste bedruckt und anschließend mit den Bauelementen bestückt, wobei die Leiterplatte dann der Anlage zum Umschmelzen der Lotpaste zugeführt wird. Der Aufschmelzvorgang ist dabei in einer gesteuerten Weise durchzuführen, der unter anderem von den Eigenschaften der Lotpaste, der Bauelemente, der Bestückungsdichte usw. abhängt. Beispielsweise sind bei Bauelementen mit sehr unterschiedlicher Baugröße die unterschiedlich langen Aufheizzeiten zu berücksichtigen, um die Lotpaste aufzuschmelzen und damit die gewünschte Qualität der Verbindungen im Hinblick auf die elektrischen, thermischen und mechanischen Eigenschaften zu gewährleisten. Daher verläuft in der Regel der Lötvorgang in der Anlage gemäß einem spezifizierten Ablauf, um damit ein gewünschtes Temperaturprofil auf dem Substrat zu erzeugen, so dass einerseits eine zuverlässige Verflüssigung der Lotpaste innerhalb eines gewünschten Zeitraums stattfindet, aber andererseits eine Überhitzung empfindlicher Bauelemente nicht stattfindet.

Seit langem sind Prozesslinienkonzepte bekannt, bei denen die notwendigen Anlagen zum Drucken, Bestücken und Löten miteinander verkettet sind. Der Zeitablauf, d.h. der Takt, einer solchen Linie wird in den überwiegenden Fällen von der Bestückzeit, d.h. der Zeit die zum Aufbringen der elektronischen Bauelemente auf das Substrat erforderlich ist, vorgegeben. Typischerweise werden einzelne Leiterplatten oder Leiterplatten in einem sog. Nutzenverbund bestückt. Aufgrund der Verkettung der entsprechenden Anlagen wird somit die Reflow-Lötanlage abhängig von der Bearbeitungszeit beim Bestücken, was auch als Bestücktakt bezeichnet wird, sequentiell beschickt. Aufgrund der thermodynamischen Erfordernisse, die zu dem gewünschten Temperaturprofil beim Aufschmelzen der Lotpaste auf dem Substrat führen, wird typischerweise eine geeignete Temperaturprofilierung innerhalb der einen oder mehreren Prozesszonen der Reflow-Lötanlage eingestellt und die Anlage verfügt üblicherweise über ein von dem Linientakt unabhängig laufendes Transportsystem, das somit die Leiterplatten entsprechend durch den thermischen Prozess führt. Somit kann durch die Anpassung der Transportgeschwindigkeit in der Reflow-Lötanlage eine gewünschte Aufheizung des Substrats und der Bauelemente und ein geeignetes Aufschmelzen der Lotpaste unabhängig von dem Bestücktakt erfolgen.

Aufgrund der zunehmenden Fortschritte in der Elektronikindustrie werden mitt-lerweile Leiterplatten aus sehr unterschiedlichen Materialien angewendet, wobei eine große Vielfalt hinsichtlich der Abmessungen und Formen auftreten kann, um den diversen Erfordernissen in vielen industriellen Gebieten Rechnung zu tragen. Starre Leiterplattenmaterialen sind unter anderem FR2, FR4 und CEM1. Diese starren Leiterplattenmaterialien werden als einzelne Substrate oder als Verbund, je nach Größe der individuellen Schaltungen, durch die Reflow-Lötanlage geführt. Es sind jedoch auch flexible Materialien, z.B. Polyimid (PI), Polyethylenteraphtalat (PET) und Polyethylen-Naphtalat (PEN) und ähnliche bekannt und werden zunehmend für viele Anwendungszwecke eingesetzt. Ein Transportverfahren für flexible Leiterplatten und darauf aufgebrachten Baugruppen besteht darin, diese auf einem durchgängigen Transportband, etwa einem Teflonband, einem Geflechtsgliederband, und dergleichen, durch die Reflow-Lötanlage zu führen. Die flexiblen Leiterplatten liegen hierbei direkt ganzflächig auf dem Transportband auf. Bei anderen Verfahren werden die einzelnen flexiblen Substrate in Hilfsrahmen oder Werkstückträger eingespannt oder eingelegt, die dann beispielsweise auf einer Stiftkette durch die Reflow-Lötanlage transportiert werden. Bei diesem Verfahren zum Transport flexibler Leiterplatten werden diese kontinuierlich mit gleichförmiger Geschwindigkeit durch die Reflow-Lötanlage geführt. Bei geeigneter Einstellung der entsprechenden Prozesszone in der Lötanlage wird jeder Punkt auf der flexiblen Leiterplatte näherungsweise mit der gleichen Wärmemenge beaufschlagt.

Wenn Substrate verarbeitet werden sollen, die eine Vielzahl von Schaltungen aufweisen, die beispielsweise aneinandergereiht sind, treten Schwierigkeiten auf, wenn das entsprechende Substrat von einer Bearbeitungsstation zur nächsten geführt wird, wie dies beispielsweise beim Verarbeiten von endlosen flexiblen Substraten der Fall ist, da dann der bestimmende Linientakt mit den thermodynamischen Erfordernissen des Aufschmelzlötvorgangs in Einklang zu bringen ist. Ein "endloses" Substrat weist in Reihe angeordnete gleiche Abschnitte, beispielsweise Schaltungen oder Leiterplatten auf, die auch als "Images" werden, wobei zwischen den einzelnen Schaltungen meist nur einige Millimeter Substrat vorhanden sind, um beispielsweise den späteren Trennvorgang zu ermöglichen. Um einen kontinuierlichen Transportvorgang in der Reflow-Lötanlage zu ermöglichen wird üblicherweise ein entsprechender "Puffer" vor der Anlage vorgesehen, um damit den unterschiedlichen Transportgeschwindigkeiten und -verfahren der einzelnen Bearbeitungsanlagen, d.h. der Bestückungseinrichtung, der Aufdruckeinrichtung und der Reflow-Prozessanlage, Rechnung zu tragen.

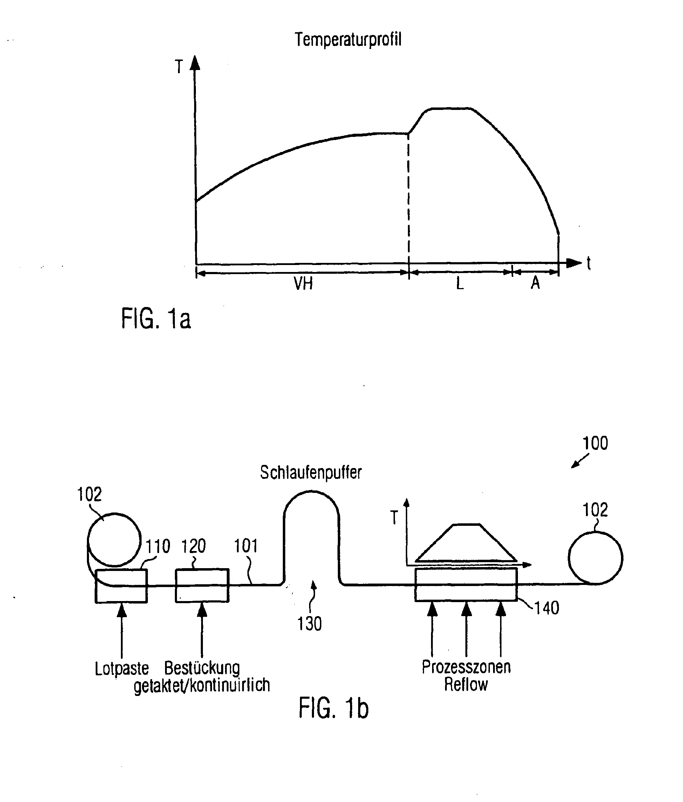

Fig. 1 a zeigt schematisch ein Temperaturprofil, das einen gewünschten Temperaturverlauf auf einem Substrat repräsentieren soll, um damit die gewünschten elektrischen, thermischen und mechanischen Verbindungen durch das Aufschmelzen herzustellen. Wie in Fig. 1 a gezeigt ist, muss zunächst das Substrat auf die erforderliche Temperatur aufgeheizt werden, wobei während einer entsprechenden Vorheizdauer, die als VH bezeichnet ist, eine möglichst gleichmäßige Erwärmung aller Bauelemente auf dem Substrat angestrebt wird. Um dies zu gewährleisten, kann eine entsprechende Transportgeschwindigkeit mit einer entsprechenden Prozesstemperatur kombiniert werden, um innerhalb des Zeitraums VH die gewünschte Temperatur zu erreichen. In einigen Anwendungen kann es vorteilhaft sein, die Schmelztemperatur während der Lötphase, die mit L bezeichnet ist, kurzfristig und mit einer festgelegten Zeitdauer zu überschreiten, um damit ein zuverlässiges Aufschmelzen zu gewährleisten, ohne dass eine Überhitzung empfindlicher Bauelemente stattfindet. Danach kann eine geeignete Abkühlphase, die mit A bezeichnet ist, folgen, die bei Bedarf durch aktives Kühlen in gewünschtem Maße eingestellt werden kann. Das in Fig. 1 a schematisch gezeigte Temperaturprofil wird in der Regel auf die Erfordernisse der zu bearbeitenden Substrate und der darauf aufgebrachten Komponenten abgestimmt, um die gewünschten zuverlässigen Verbindungen zu erhalten. Das Temperaturprofil wird in der Regel durch das Vorgeben einer oder mehrerer geeigneter Prozesstemperaturen und durch die Transportgeschwindigkeit und damit Verweildauer der entsprechenden Substrate bei einer vorgegeben Prozesstemperatur eingestellt. Beispielsweise können für komplexere Temperaturprofile, mehrere Prozesszonen mit jeweils vorgegeben Temperaturen vorgesehen sein, die dann mit der jeweiligen Transportgeschwindigkeit durchlaufen werden, so dass sich das gewünschte Temperaturprofil einstellt.

Fig. 1b zeigt schematisch ein entsprechendes verkettetes System zum Verarbeiten von endlosen flexiblen Substraten, die darauf aufgedruckt entsprechende Schaltungen aufweisen. Ein System 100 weist dazu ein endloses Substrat 101 auf, das in Form eines flexiblen Bandes mittels entsprechenden Trägern 102, beispielsweise entsprechende Materialrollen, die in geeigneter Weise angetrieben werden, durch Verarbeitungsstationen 110, 120, 130 und 140 geführt wird. Dabei repräsentiert die Station 110 eine Druckstation zum Aufdrucken der Lotpaste auf das Band 101, die Station 120 eine Bestückungsstation, in der entsprechende Bauelemente automatisch aufgebracht werden, und die Station 140 repräsentiert eine Reflow-Lötanlage mit einem geeignet eingestellten Temperaturprofil, beispielsweise in Form geeignet eingestellter Prozesszonen oder in Form einer einzelnen Prozesszone, abhängig von der Komplexität des entsprechenden Temperaturprofils. Ferner ist vor der Reflow-Lötanlage 140 ein Substratpuffer, in Form eines Schlaufenpuffers, 130 vorgesehen, der eine gewisse Entkopplung der Transportgeschwindigkeiten in den Stationen 110, 120 und der Station 140 ermöglicht. Wenn z.B. die Bestückung in der Station 120 in einer im Wesentlichen getakteten Weise erfolgt, wobei das Substrat während der Bestückung ruht oder gegebenenfalls auch kontinuierlich weiterbewegt wird und durch Abwickeln des Bandes 101 von der linken Rolle 102, ohne dass das Substrat in rechten Rolle 102 aufgewickelt wird, damit durch die Station 140 geführt wird, kann somit im Schlaufenpuffer 130 entsprechend seiner Kapazität eine gewisse Länge des Substrats 101 und damit eine gewisse Anzahl an darauf aufgedruckten Schaltungen gespeichert werden. Somit kann in einem gewissen Umfang die Transportgeschwindigkeit der Station 140 kontinuierlich entsprechend dem erforderlichen Temperaturprofil aufrechterhalten werden. Der Schlaufenpuffer 130 bietet jedoch in der Regel keine beliebige Reserve, da die Höhe der Schlaufe im Wesentlichen die zur Verfügung stehende Reservelänge bestimmt, so dass ein kontinuierlicher Transport in der Station 140 nicht möglich ist, wenn sich der Bestücktakt und die Reservelänge in den Schlaufenpuffer 130 nicht mit einem kontinuierlichen Transport in der Station 140 vereinbaren lassen. In diesem Falle muss der Transport in der Station 140 in getakteter Weise erfolgen, wobei das gesamte Temperaturprofil, wenn ein im Wesentlichen einstufiger Erwärmungsprozess vorgesehen ist, oder Abschnitte des Temperaturprofils im zeitlich aufeinander folgenden Takten jeweils eines zu bearbeitenden Substratbereichs des endlosen flexiblen Substrats 101 durchlaufen wird. In dieser Situation entspricht die Taktzeit, d.h. die Zeit zwischen zwei Transportaktivitäten, nicht immer der notwendigen optimalen Verweilzeit in dem jeweiligen Abschnitt der Station 140, der für einen entsprechenden Abschnitt des gewünschten Temperaturprofils zuständig ist. D.h., bei einer vorgegebenen Prozesstemperatur einer Prozesszone entspricht die durch vorhergehende Stationen vorgegebene Taktzeit in der Regel nicht der optimalen Verweilzeit in dieser Zone, die bei einem unabhängigen Transport durch die Station 140 angestrebt würde. Dadurch können Lötstellen entstehen, die in ihren Eigenschaften nicht den gewünschten Anforderungen entsprechen.

Ferner ist in der Regel der während eines einzelnen Schrittes zu bearbeitende Substratabschnitt bei Wechsel der Produkte in seiner Länge nicht auf die entsprechenden Prozesszonenabschnitte in der Reflow-Lötanlage abgestimmt, die Substratabschnitte mit anderen Größen erfordern, wodurch es dann beispielsweise zu unerwünschten thermischen Mehrbelastungen in zueinander benachbarten Bereichen der Schaltungen auf dem Substrat kommen kann.

Es ist daher eine Aufgabe der vorliegenden Erfindung, Mittel anzugeben, um die zuvor genannten Nachteile bei der Verarbeitung von Substraten und insbesondere von endlosen Substraten in Reflow-Lötanlagen zu vermeiden oder zumindest in ihrer Auswirkung zu reduzieren.

Erfindungsgemäß wird diese Aufgabe gelöst, indem eine Anpassung des Temperaturprofils in einer Reflow-Lötanlage auf der Grundlage einer vorgegebenen Transportgeschwindigkeit erfolgt, wie es in einem Verfahren gemäß Patentanspruch 1, einer Reflow Lötanlage gemäß Patentanspruch 8 und einem System gemäß Patentanspruch 14 definiert wird. In einem Aspekt der vorliegenden Erfindung wird dazu ein Verfahren zum Betreiben einer Reflow-Lötanlage bereitgestellt, wobei Substrate mit einer Rate zur Bearbeitung zugeführt werden, die durch einen dem Bearbeitungsprozess in der Reflow-Lötanlage vorgeordneten Bearbeitungsprozess festgelegt ist. Das Verfahren umfasst dabei das Steuern der Temperatur der Substrate in einer Prozesszone der Reflow-Lötanlage unter Berücksichtigung eines vorgegebenen Solltemperaturprofils und der festgelegten Zuführrate.

Durch das Steuern der Temperatur der Substrate sowohl auf der Grundlage der vorgegebenen Solltemperatur und deren Verlauf sowie auf der Grundlage der festgelegten Zuführrate kann eine gewünschte Temperaturprofilierung unabhängig von der Transportgeschwindigkeit erreicht werden, so dass bei kontinuierlicher oder auch getakteter Beschickung der Reflow-Lötanlage eine Kopplung zu den vorhergehenden Bearbeitungsprozessen bestehen kann, ohne die Qualität der Lötverbindungen zu beeinflussen. D.h., in der Reflow-Lötanlage findet eine Anpassung der Prozesszone statt, die eine entsprechende Einstellung der jeweiligen Prozesstemperaturen und/oder der effektiv wirksamen Länge entsprechender Prozesszonen beinhalten kann, um damit ein höheres Maß an Flexibilität bei der Anpassung an externe Transportgeschwindigkeiten zu ermöglichen, ohne die gewünschte Temperaturprofilierung zu beeinträchtigen.

In einer weiteren Ausführungsform werden die Substrate schrittweise mit einer vorgegebenen Taktrate entsprechend der festgelegten Zuführrate zugeführt, wobei ein Takt zur Bearbeitung jedes Substrats in der Prozesszone durch zwei aufeinander folgende Transportaktivitäten definiert ist.

Somit erfolgt eine taktweise Beschickung der Reflow-Lötanlage, wodurch insbesondere aufwendige Schlaufenpuffer vermieden oder in ihrer Größe deutlich reduziert werden können, ohne damit eine Beeinträchtigung der Verarbeitungsqualität in der Lötanlage hervorzurufen.

In einer Ausführungsform umfasst das Steuern der Temperatur des Substrats das Einstellen der Dauer einer kumulierten Beaufschlagung eines Substrats mit einer ersten Prozesstemperatur während eines Taktes. Auf diese Weise kann die effektive Zeitdauer der Temperaturbeaufschlagung während einer entsprechenden Ruhezeit des Substrats in der Prozesszone oder einem Abschnitt davon, der entsprechenden Transportgeschwindigkeit oder dem entsprechenden Taktzyklus angepasst werden, so dass im zeitlichen Mittel des entsprechenden Taktes eine gewünschte Aufheizung bzw. Abkühlung des Substrats erreicht werden kann. Beispielsweise kann durch Ankoppeln und Abkoppeln einer geeigneten Wärmequelle oder durch eine entsprechende Modifizierung des Wärmeleitwiderstandes zwischen der Wärmequelle und dem Substrat oder durch eine geeignete Ansteuerung der Wärmequelle eine mittlere Zeitdauer der Temperaturbeaufschlagung erreicht werden, wobei die Prozesstemperatur selbst auf einem relativ konstanten Niveau gehalten wird, wodurch sich eine einfache und zuverlässige Betriebsweise erreichen lässt.

In einer weiteren vorteilhaften Ausführungsform umfasst das Steuern der Temperatur der Substrate ferner das Einstellen der kumulierten Beaufschlagung des Substrats mit einer zweiten Prozesstemperatur, die von der ersten Prozesstemperatur verschieden ist. Auf diese Weise werden zwei Wärmequellen mit gut definierter Prozesstemperatur in zeitlich gesteuerter Weise mit dem Substrat gekoppelt, um damit eine gewünschte Temperaturbeaufschlagung im zeitlichen Mittel während des Taktes zu ermöglichen. Beispielsweise können entsprechende Wärmequellen mit hoher Effizienz auf den entsprechenden Prozesstemperaturen gehalten werden, die dann in einer geeigneten Abfolge mit dem Substrat gekoppelt werden, um damit das gewünschte Temperaturverhalten zu erreichen.

In einer weiteren vorteilhaften Ausführungsform umfasst das Steuern der Temperatur der Substrate das in Kontakt bringen der Substrate mit einer ersten Wärmeleitoberfläche. Somit wird die Wärme effizient in Form eines mechanischen Kontaktes des Substrats mit einer entsprechenden Wärmeleitoberfläche bewerkstelligt, so dass diese Art der Wärmeübertragung eine großflächige und gleichmäßige Temperaturverteilung ermöglicht. In diesem Zusammenhang ist eine Wärmeleitoberfläche als eine Materialschicht zu verstehen, die somit eine Grenzfläche zwischen dem Substrat und einer mit der Wärmeleitoberfläche in mechanischer Verbindung stehenden Wärmequelle bildet, wobei die Wärmequelle in Form einer Widerstandsheizung, Strahlungsquellen, Konvektion eines Fluids, etc. vorgesehen sein kann.

In einer weiteren vorteilhaften Ausführungsform wird eine zweite Wärmeleitoberfläche mit dem Substrat in Kontakt gebracht, wobei die zweite Wärmeleitoberfläche eine Oberflächentemperatur aufweist, die sich von der Oberflächentemperatur der ersten Wärmeleitoberfläche unterscheidet. Somit kann das Substrat mit zwei unterschiedlichen Prozesstemperaturen, d.h. den beiden unterschiedlichen Oberflächentemperaturen der Wärmeleitoberflächen beaufschlagt werden, um damit in definierter Weise eine zeitlich gemittelte Wärmebehandlung während eines entsprechenden Taktes zu ermöglichen.

In einer weiteren vorteilhaften Ausführungsform werden die erste und die zweite Wärmeleitoberfläche zeitlich aufeinander folgend mit dem Substrat durch eine Verschiebung parallel zu einer durch das Substrat definierten Ebene in Kontakt gebracht. Somit kann das Substrat in effizienter Weise durch mechanische Bewegung der entsprechenden Wärmeleitoberflächen mit einer entsprechenden Prozesstemperatur geeignet beaufschlagt werden, wobei die Ankopplung bzw. Abkopplung der jeweiligen Wärmeleitoberfläche aufgrund der parallel zur Substratebene erfolgenden Bewegung in effizienter Weise erfolgen kann. Z.B. lassen sich entsprechende Transportmechanismen in Form von Motoren, pneumatischen oder hydraulischen Zylindern, und dgl. vorteilhaft einsetzen, wobei durch eine entsprechende mechanische Kopplung der beiden Wärmeleitoberflächen in einigen Ausführungsformen eine entsprechende einfachere Ansteuerung der mechanischen Bewegung erfolgen kann, wobei dann das Substrat entweder mit der ersten Prozesstemperatur oder der zweiten Prozesstemperatur beaufschlagt wird.

In einer weiteren vorteilhaften Ausführungsform werden zusätzlich oder alternativ zu der zuvor beschriebenen Bewegung die erste und die zweite Wärmeleitoberfläche zeitlich aufeinander folgend mit dem Substrat durch eine Verschiebung im Wesentlichen senkrecht zu der durch das Substrat definierten Ebene in Kontakt gebracht. Auf diese Weise lässt sich der für die mechanische Bewegung der Wärmeleitoberflächen erforderliche Platz in einer Fertigungslinie deutlich reduzieren, da in der Regel eine senkrecht zur Substratebene stattfindende Bewegung, d.h. in der Regel eine vertikale Bewegung zu keinem zusätzlichen Installationsflächenbedarf in der Prozesslinie führt. Insbesondere kann bei einer Kombination einer parallel und senkrecht zur Substratebene erfolgenden Bewegung zur An- und Abkopplung der Wärmeleitoberflächen ein hohes Maß an Flexibilität bei nur relativ geringem Platzbedarf erreicht werden. Dabei sind in einigen Ausführungsformen auch Bewegungen in und entgegen der Transportrichtung der Substrate vorgesehen, so dass vielfältige Kombinationen möglich sind, um während eines einzelnen Taktes das Substrat mit einer geeigneten Wärmeleitoberfläche in Kontakt zu bringen. In anderen Ausführungsbeispielen sind mehr als zwei Wärmeleitoberflächen vorgesehen, die durch mechanische Bewegung während eines einzelnen Taktes mit dem Substrat in Kontakt gebracht werden können. Auf diese Weise kann eine sehr feinfühlige Einstellung des gewünschten Temperaturprofils innerhalb jedes einzelnen Taktes erreicht werden.

In einer weiteren vorteilhaften Ausführungsform weist die Prozesszone eine Heizfläche auf, deren effektive Größe einer Größe der auf den Substraten aufgebrachten Schaltungen angepasst wird.

In dieser Ausführungsform kann somit eine Einstellung der wirksamen Größe der Heizfläche so stattfinden, dass bei variierender Größe der einzelnen Schaltungen oder Images auf den Substraten ein getakteter Transport ohne entsprechende Überschneidungen und damit thermischen Mehrbelastungen möglich ist. Durch diese einstellbare effektive Größe der Heizfläche lässt sich auch die entsprechende wirksame Länge der Prozesszone in effizienter Weise auf die durch die auf die Substrate aufgebrachten Schaltungen bestimmte Größe anpassen.

In einer vorteilhaften Ausführungsform wird die effektive Größe der Heizfläche durch Austauschen einer ersten Heizfläche mit einer ersten Größe durch eine zweite Heizfläche mit einer zweiten Größe angepasst. Die Fähigkeit des Austauschens der einzelnen Heizfläche ergibt somit ein hohes Maß an Flexibilität bei der Anpassung des durch die Prozesszone erzeugten Temperaturprofils an die jeweilige Größe der entsprechenden Schaltungen auf den Substraten.

In einer weiteren vorteilhaften Ausführungsform wird die effektive Größe der Heizfläche durch Einstellen einer Sollprozesstemperatur in ausgewählten Abschnitten der Heizfläche angepasst. Augrund dieser Ausbildung kann eine entsprechende Größenanpassung durch geeignetes Ansteuern der Heizflächenabschnitte erfolgen, so dass gegebenenfalls mechanische Arbeiten zum Einstellen der effektiven Größe weitestgehend vermieden werden können. Auf diese Weise wird die Flexibilität der Lötanlage weiter verbessert, da die effektive Größe der Heizfläche und damit der Prozesszone rasch, bei Bedarf auch während des Betriebs der Anlage, geändert werden kann.

In einer weiteren vorteilhaften Ausführungsform weist die Prozesszone eine Kühlfläche auf, deren effektive Größe einer Größe der auf den Substraten aufgebrachten Schaltungen angepasst wird. Hier gilt in ähnlicher Weise die für die zuvor beschriebenen Heizflächen dargelegte Erläuterung, dass somit eine sehr effiziente Anpassung an die entsprechenden zu verarbeitenden Produkte erfolgen kann, wobei das Vorhandensein von entsprechenden Kühlflächen zu einer effizienten Einstellung des gewünschten Temperaturprofils beiträgt.

In einer weiteren Ausführungsform wird die effektive Größe der Kühlfläche durch Austauschen einer ersten Kühlfläche mit einer ersten Größe durch eine zweite Kühlfläche mit einer zweiten Größe oder durch das Einstellen einer Sollprozesstemperatur in ausgewählten Abschnitten der Kühlfläche angepasst. Auch für diese Aspekte gelten die zuvor dargelegten Vorteile, wobei die speziell angepasste Größe der Kühlflächen auch zu einem definierten Temperaturverhalten während der an sich weniger kritischen Abkühlphase der Substrate führt.

In einigen Ausführungsformen werden die Substrate in Form eines zusammenhängenden Verbundes zugeführt, wobei in einer Ausführungsform der zusammenhängende Verbund flexibel ist. Auf diese Weise kann das erfindungsgemäße Verfahren effizient für die Verarbeitung von sog. "Endlossubstraten" eingesetzt werden, wobei eine aufwendige Entkopplung der jeweiligen Verarbeitungsstationen, die in konventionellen Anlagen auch nur teilweise und unzureichend gelingt, im Wesentlichen vermieden werden kann, da sich die Prozesszone der Reflow-Lötanlage in geeigneter Weise an die Transportgeschwindigkeiten und bei Bedarf auch an die Größen der entsprechenden Substratabschnitte anpassen kann.

In einer vorteilhaften Ausführungsform wird zumindest zeitweise während des Zuführens der Substrate der flexible Verbund gespannt. Auf diese Weise wird eine effiziente Wärmeübertragung ermöglicht, insbesondere wenn die Wärmeübertragung zumindest teilweise durch entsprechende Wärmeleitoberflächen erfolgt, die mechanisch mit dem Substrat in Kontakt gebracht werden. Durch das Vermeiden von Verwindungen/Wölbungen in flexiblen Substraten wird somit eine sehr homogene Aufheizung bzw. Abkühlung der Substrate gewährleistet.

In einer weiteren vorteilhaften Ausführungsform werden die Substrate, wenn diese mittels entsprechender Wärmeleitoberflächen mit Wärme beaufschlagt werden, in der Prozesszone zumindest teilweise während eines Taktes angesaugt. Damit wird der Kontakt zwischen der Wärmeleitoberfläche und dem Substrat verbessert, so dass eine gut definierte Grenzfläche gebildet wird, die somit für definierte thermische Verhältnisse sorgt. Insbesondere im Zusammenwirken mit einem gleichzeitigen oder vorhergehenden Spannen der Substratbereiche wird damit auch eine effiziente Ansaugung der Substratoberfläche auf die Wärmeleitoberflächen gewährleistet.

In weiteren vorteilhaften Ausführungsformen werden die Substrate in der Prozesszone mit einer weiteren Wärmequelle und/oder einer Wärmesenke zusätzlich zur Ankopplung an eine Wärmeleitoberfläche gekoppelt, wobei diese weiteren Wärmequellen oder Wärmesenken unabhängig von der Wärmeleitoberfläche sind. Damit kann die Temperatur auf dem Substrat in noch effizienterer Weise gesteuert werden, da die zusätzlichen Wärmequellen oder Wärmesenken eine einheitliche und relativ gleichmäßige Basiswärmebeaufschlagung ergeben, während die Wärmeleitoberflächen dann für die gewünschte eigentliche Temperaturprofilierung sorgen können. So können beispielsweise an sich wenig effiziente Wärmequellen oder Wärmesenken, etwa Peltier-Elemente, in Verbindung mit den Leitoberflächen eingesetzt werden, die dann in Kombination eine sehr flexible räumliche und zeitliche Anpassung der Prozesstemperatur in der Wärmeleitoberfläche ermöglichen, während ein großer Anteil der zu handhabenden Wärmemenge von den unabhängigen Wärmequellen oder Wärmesenken geliefert werden kann.

In einer weiteren Ausführungsform wird die Prozesszone mit zumindest einem Prozessgas gespült. Damit wird eine unerwünschte Kontamination der Umgebung sowie der Substrate deutlich reduziert, wobei in einigen Ausführungsformen auch unterschiedliche Prozessgase je nach Produktart, gewünschtem Bearbeitungsverfahren, und dgl. eingesetzt werden können.

In einem weiteren Aspekt der vorliegenden Erfindung wird die zugrunde liegende Aufgabe gelöst mittels einer Reflow-Lötanlage, die eine Prozesszone mit einem in Transportrichtung von Substraten unter Verwendung einer oder mehrerer Wärmeleitoberflächen erzeugbaren Temperaturprofil aufweist. Dabei ist das Temperaturprofil während der Bearbeitung der Substrate zur Einstellung eines gewünschten Temperaturverlaufs in den Substraten veränderbar.

In der erfindungsgemäßen Lötanlage wird somit ein Prozesstemperaturprofil, d.h. eine Aneinanderreihung von unterschiedlichen Prozesstemperaturen in einer äußerst flexiblen Weise ermöglicht, wobei die einzelnen Prozesstemperaturen durch Kontakt mittels Wärmeleitoberflächen auf die Substrate übertragen werden. Dabei kann die Änderung bzw. Anpassung des Prozesstemperaturprofils so erfolgen, dass eine Harmonisierung mit einer vorgegebenen Zuführrate der Substrate erreicht wird, so dass eine Verkettung mit vorhergehenden Prozessstationen möglich ist, und insbesondere Endlossubstrate mit einem gewünschten Temperaturverlauf in den Substraten verarbeitet werden können.

Dazu weist in einer Ausführungsform die Lötanlage eine erste Wärmeleitoberfläche in der Prozesszone auf, die während des Betriebs bei Ruhelage des Substrats thermisch mit diesen koppelbar und entkoppelbar ist. D.h., die Wärmeleitoberfläche, die eine gut definierte Prozesstemperatur aufweist, kann durch Änderung des thermischen Übergangswiderstands zwischen der Wärmeleitoberfläche und dem Substrat angekoppelt oder abgekoppelt werden, wobei dies als eine deutliche Änderung des entsprechenden thermischen Widerstands zu verstehen ist, auch wenn eine gewisse Restkopplung weiterhin besteht.

In einer Ausführungsform ist die erste Wärmeleitoberfläche mit einer Antriebseinrichtung zum Bewegen der ersten Wärmeleitoberfläche gekoppelt. Aufgrund der Transporteinrichtung kann somit die Wärmeleitoberfläche so bewegt werden, dass ein mechanischer Kontakt mit dem Substrat gebildet oder aufgehoben wird, so dass damit eine entsprechende thermische Ankopplung oder Entkopplung in effizienter Weise erreicht wird.
In weiteren Ausführungsformen ist dabei die Antriebseinrichtung ausgebildet, eine Bewegung im Wesentlichen parallel zu einer durch das Substrat definierten Ebene und/oder in einer im Wesentlichen senkrecht zu der durch das Substrat definierten Ebene zu bewirken. Wie bereits zuvor beschrieben ist, kann somit damit eine effiziente Wärmebeaufschlagung der Substrate erfolgen, wobei ein hohes Maß an Flexibilität für die Anzahl der zu verwendenden Wärmeleitoberflächen sowie deren mechanische Bewegung gegeben ist.

Vorteilhafterweise besitzt die Wärmeleitoberfläche einen reduzierten Gleitreibungskoeffizienten, so dass auch bei einer parallel zur Substratebene stattfindenden Verschiebung der entsprechenden Wärmeleitoberfläche nur ein geringer mechanischer Kraftaufwand erforderlich ist und damit auch nur eine geringfügige Beeinflussung des Substrats erfolgt. Zu diesem Zweck kann die Wärmeleitoberfläche eine Beschichtung mit geringem Gleitreibungskoeffizienten und/oder eine polierte Oberfläche aufweisen, so dass die gewünschten mechanischen Eigenschaften erreicht werden. Beispielsweise können Materialien wie Teflon, Grafit, und dgl. als Beschichtungsmaterialien oder als Materialien für die Wärmeleitoberflächen verwendet werden, um damit ein gleitendes Inkontaktbringen der Wärmeleitoberfläche mit dem Substrat zu ermöglichen.

In einer vorteilhaften Ausführungsform weist die Wärmeleitoberfläche geeignete Aussparungen auf, die mit einer Unterdruckquelle gekoppelt werden können. Auf diese Weise kann das Substrat durch die Wärmeleitoberfläche hindurch angesaugt werden, so dass eine im Wesentlichen gleichmäßige Auflage des Substrats und damit auch eine gleichmäßige Wärmeübertragung stattfindet. Die entsprechenden Aussparungen können als ein oder mehrere Kanäle in der Wärmeleitoberfläche ausgebildet sein, oder die Wärmeleitoberfläche kann ein poröses Material aufweisen, das eine Fluidverbindung mit der entsprechenden Unterdruckquelle herstellen kann.

In einer weiteren vorteilhaften Ausführungsform ist eine Spannvorrichtung vorgesehen, die ausgebildet ist, zumindest zeitweilig die Spannung eines Substratbandes, wenn die Anlage zur Bearbeitung von kontinuierlichen Substratbändern ausgebildet ist, in der Prozesszone zu erhöhen. Somit wird eine gleichmäßige Wärmeübertragung ermöglicht, da entsprechende Verwindungen oder Wölbungen in dem Substratband deutlich reduziert oder gänzlich vermieden werden können, wobei insbesondere in Verbindung mit einer entsprechenden Ausbildung der Wärmeleitoberfläche zum Ansaugen des Substrats eine sehr effiziente Wärmeübertragung erfolgt.

In einigen Ausführungsformen sind entsprechende Mittel vorgesehen, um die Unterdruckquelle und/oder die Spannvorrichtung in geeigneter Weise synchron mit entsprechenden Antriebseinrichtungen für die Wärmeleitoberfläche zu betreiben, so dass der Austausch der entsprechenden Wärmeleitflächen während einer Ruhephase der Substrate in effizienter Weise möglich ist. Beispielsweise kann während einer mechanischen Bewegung die Wärmeleitoberfläche die Unterdruckquelle abgeschaltet oder belüftet werden, um damit eine entsprechende Bewegung in horizontaler oder vertikaler Richtung zu erleichtern. In ähnlicher Weise kann auch die Spanneinrichtung geeignet betätigt werden, um eine entsprechende Bewegung der Wärmeleitoberfläche zu begünstigen. Beispielsweise kann die Spannvorrichtung unmittelbar vor dem Verschieben einer Wärmeleitoberfläche in umgekehrter Weise betätigt werden, um absichtlich eine geringe Wölbung zu erreichen um damit das Abziehen der Wärmleitoberfläche zu erleichtern. Bei Eintreffen einer anderen Wärmeleitoberfläche kann dann eine entsprechende Straffung des Substratbandes erfolgen, so das weiterhin eine relativ gleichmäßige und effiziente Wärmeübertragung stattfindet.

In einer weiteren vorteilhaften Ausführungsform ist die Prozesszone in getakteter Weise mit dem Substratband beschickbar und es ist mindestens ein Substratabschnitt des Bandes zwischen zwei aufeinander folgenden Transportaktivitäten zum Befördern des Bandes mit einer ersten Prozesstemperatur und einer zweiten verschiedenen Prozesstemperatur beaufschlagbar. Damit ist die Lötanlage für einen getakteten Betrieb geeignet, wobei die entsprechenden Transportaktivitäten von vorgeordneten oder nachgeordneten Bearbeitungsstationen vorgegeben werden kann, ohne dass die Qualität der Lötverbindungen beeinträchtigt wird. Dazu können eben die entsprechenden Substratabschnitte zwischen den einzelnen Transportaktivitäten mit mindestens zwei unterschiedlichen Prozesstemperaturen durch Kontakt mit entsprechenden Wärmeleitoberflächen beaufschlagt werden. Durch die zeitliche Steuerung dieser Temperaturbeaufschlagung wird somit eine mittlere Prozesstemperatur erreicht.

In weiteren vorteilhaften Ausführungsformen können von der Wärmeleitoberfläche unabhängige Wärmequellen und/oder Wärmesenken vorgesehen sein, um damit in der zuvor beschriebenen Weise eine effiziente Temperaturprofilierung zu erreichen, wobei die Wärmeleitoberflächen als "modulierende" Wärmequellen oder Wärmesenken dienen und ein wesentlicher Anteil des Grundwärmebedarfs durch die zusätzlichen Wärmequellen und/oder Wärmesenken bereitgestellt wird.

In einer weiteren vorteilhaften Ausführungsform weist die Wärmeleitoberfläche mindestens einen Abschnitt auf, der während des Kontakts mit einem Substrat mit zwei verschiedenen Prozesstemperaturen betreibbar ist. Auf diese Weise kann eine lokal begrenzte Fläche mit unterschiedlichen Temperaturen betrieben werden, wobei der lokal begrenzte Abschnitt dazu dienen kann, die Größe der Wärmeleitoberfläche den entsprechenden Substratbereichen anzupassen und/oder die mittlere Temperatur der Wärmeleitoberfläche in geeigneter Weise einzustellen.

In einer Ausführungsform ist ferner eine Schalteinrichtung vorgesehen, die ausgebildet ist, den Abschnitt zeitlich aufeinander folgend auf eine erste Prozesstemperatur und eine zweite Prozesstemperatur zu steuern. Somit kann mittels der Schalteinrichtung eine gewünschte zeitliche Sequenz aus erster und zweiter Prozesstemperatur in dem Abschnitt erzeugt werden. Dabei kann der Abschnitt eine entsprechend geringe Wärmekapazität aufweisen, so dass eine wirksame Änderung der Temperatur innerhalb einer kurzen Zeitdauer, d.h. innerhalb von wenigen Sekunden ermöglicht wird, so dass bereits nach sehr kurzer Einschwingzeit eine definierte Prozesstemperatur zur Verfügung steht.

In einer weiteren vorteilhaften Ausführungsform sind mehrere Abschnitte vorgesehen und die Schalteinrichtung ist ferner ausgebildet, zumindest einige erste Abschnitte auf eine erste Prozesstemperatur und einige zweite Abschnitte auf eine zweite Prozesstemperatur zu steuern, um die wirksame Länge der Prozesszone in Bezug auf die erste und zweite Prozesstemperatur einzustellen. Somit kann die wirksame Länge der Prozesszone ohne mechanische Eingriffe sehr effizient eingestellt werden, so dass in sehr flexibler Weise unterschiedliche Substratabschnitte und damit Schaltungen auf entsprechenden Endlossubstraten verarbeitet werden können. Insbesondere kann dazu zumindest die Abmessung der mehreren Abschnitte in Längsrichtung, d.h. in der Transportrichtung, der Lötanlage so klein gewählt werden, dass sich für viele übliche Substratgrößen eine entsprechend ausreichende feingliedrige Unterteilung ergibt, so dass keine unerwünschten thermischen Mehrbelastungen oder unterschiedliche Prozesstemperaturen an Randabschnitten eines Substratbereichs auftreten. Beispielsweise kann mit einer Abmessung in Längsrichtung von einigen Millimetern in der Regel eine ausreichend feine Unterteilung bereitgestellt werden, so dass eine Vielzahl typischer Substratgrößen abgedeckt wird, indem eine geeignete Anzahl der ersten und zweiten Abschnitte aufeinander folgend ausgewählt werden, wobei bei Bedarf auch ein Übergangsabschnitt vorgesehen werden kann, der beispielsweise als Puffer zwischen den ersten und zweiten Abschnitten dienen kann.

In anderen Ausführungsformen können abwechselnd erste und zweite Abschnitte vorgesehen werden, um innerhalb der gleichen wirksamen Heizfläche, die der Größe des entsprechenden Substratabschnitts entspricht, diesen mit abwechselnd unterschiedlichen Prozesstemperaturen zu beaufschlagen, wobei die feine Unterteilung in Verbindung mit den Wärmeleitfähigkeiten der Oberfläche zu einer dennoch im Wesentlichen gleichmäßigen Temperaturverteilung über die Oberfläche hinweg führen.

In einer weiteren vorteilhaften Ausführungsform ist eine Gaszufuhreinrichtung vorgesehen, die ausgebildet ist, die Prozesszone mit einem oder mehreren Prozessgasen zu spülen.
Gemäß einem weiteren Aspekt der vorliegenden Erfindung wird die Aufgabe gelöst, indem ein System zur Herstellung von gedruckten Schaltungen auf einem kontinuierlichen Substratmaterial bereitgestellt wird. Das System umfasst eine Druckeinrichtung zum Aufdrucken eines Lotmaterials auf einen Bereich des Substratmaterials mit vorgegebener Größe und eine Bestückungseinrichtung zum Aufbringen von Komponenten auf jeden Bereich mit vorgegebener Größe. Ferner ist eine Transporteinrichtung vorgesehen, um das kontinuierliche Substratmaterial zu befördern. Es ist eine Reflow-Löteinrichtung mit einer Prozesszone und einem in Transportrichtung durch Verwendung einer Wärmeleitoberfläche erzeugbarem Prozesstemperaturprofil vorgesehen, wobei das Temperaturprofil abhängig von einer mittleren Transportgeschwindigkeit der Transportrichtung einstellbar ist.

Wie zuvor bereits dargelegt ist, kann somit eine effiziente verkettete Herstellung von gedruckten Schaltungen auf kontinuierlichen Substratmaterialien gewährleistet werden, wobei die thermodynamischen Bedingungen in der Löteinrichtung aufgrund der Ausbildung der Prozesszone der Transportgeschwindigkeit anpassbar ist, so dass beispielsweise bei einer kontinuierlichen Transportgeschwindigkeit innerhalb der Löteinrichtung konventionelle Schlaufenpuffer in ihrer Größe ausreichend sind, um einen kontinuierlichen Betrieb zu bewerkstelligen. Ferner kann auch bei einer getakteten Betriebsweise in der Löteinrichtung in jeder Prozesszone ein entsprechendes Prozesstemperaturprofil eingerichtet werden, so dass die der Größe und der Art der gedruckten Schaltung erforderlichen thermodynamischen Verhältnisse beim Aufheizen der Bauelemente und dem Aufschmelzen der Lotpaste erreicht werden. Dabei kann insbesondere die Prozesstemperaturprofilierung an die Gegebenheiten der Bestückungseinrichtung angepasst werden, die in der Regel die längste Bearbeitungszeit pro Substratbereich erfordert.

Weitere vorteilhafte Ausführungsformen sind auch in den abhängigen Patenansprüchen dargestellt und gehen auch aus der weiteren detaillierten Beschreibung hervor, wobei Bezug genommen wird auf die begleitenden Zeichnungen, in denen
- Fig. 1a: schematisch ein Temperaturprofil zeigt, wie es typischerweise für das Aufschmelzen von Bauelementen auf Leiterplatten verwendet wird;
- Fig. 1b: schematisch ein konventionelles System zur Herstellung gedruckter Schaltungen auf einem flexiblen Endlossubstrat zeigt, wobei ein Schlaufenpuffer nur eine gewissen Reservelänge für einen kontinuierlichen Betrieb einer Reflow-Löteinrichtung bereitstellt;
- Fig. 2a: schematisch eine Lötanlage gemäß der vorliegenden Erfindung zeigt, wobei eine Prozesszone entsprechend den gewünschten thermodynamischen Erfordernissen des Lötvorgangs und in Abhängigkeit von der mittleren Transportgeschwindigkeit einstellbar ist;
- Fig. 2b: schematisch eine Anordnung von Wärmeleitoberflächen zeigt, die mit einer Antriebseinheit mechanisch bewegbar sind;
- Fig. 2c: schematisch ein Zeitablaufdiagramm in einer typischen getakteten Betriebsweise darstellt, wobei die Bestückungszeit im Wesentlichen die einzelnen Bearbeitungsphasen in der Prozesszone vorgibt;
- Fig. 2d: schematisch eine Prozesszone mit mehreren Wärmeleitoberflächen darstellt, die horizontal verschiebbar sind, um ein gewünschtes Prozesstemperaturprofil einzustellen;
- Fig. 2e: schematisch eine Prozesszone mit mehreren Wärmeleitoberflächen zeigt, die horizontal und vertikal verschiebbar sind, wodurch sich eine geringere laterale Abmessung der Prozesszone ergibt;
- Fig. 2f: schematisch eine Prozesszone zeigt, in der Wärmeleitoberflächen mit unterschiedlicher Größe gezeigt sind, um eine Anpassung an die Größe des zu bearbeitenden Substratabschnitts zu ermöglichen;
- Fig. 2g: schematisch einen Bereich einer Lötanlage bzw. eines Verarbeitungssystems zeigt, in der zumindest lokal Verwindungen/Wölbungen in einem flexiblen Substrat durch eine Spannvorrichtung reduziert oder behoben werden können;
- Fig. 2h: schematisch eine Antriebseinrichtung einer Wärmeleitoberfläche zeigt, um diese vertikal zu verschieben, wobei die Wärmeleitoberfläche eine geeignete Oberflächenstruktur aufweist, um damit ein Ansaugen des Substrats zu ermöglichen;
- Fig. 3a: schematisch eine Wärmeleitoberfläche mit einer Vielzahl von einzelnen Abschnitten zeigt, wobei eine Schalteinrichtung die einzelnen Abschnitte individuell mit einer vorgegebenen Prozesstemperatur betreiben kann;
- Fig. 3b: schematisch die Prozesszone aus Fig. 3a zeigt, wobei die einzelnen Abschnitte der Wärmeleitoberfläche durch entsprechende Ansteuerung auf die Größe der zu bearbeitenden Substratbereiche angepasst und mit geeigneten Prozesstemperaturen betrieben werden und
- Fig. 4: schematisch ein System zeigt, in dem die Verarbeitung eines flexiblen Endlossubstrats mittels einer Lötanlage mit einer in Abhängigkeit der Transportgeschwindigkeit einstellbaren Prozesszone gezeigt ist.

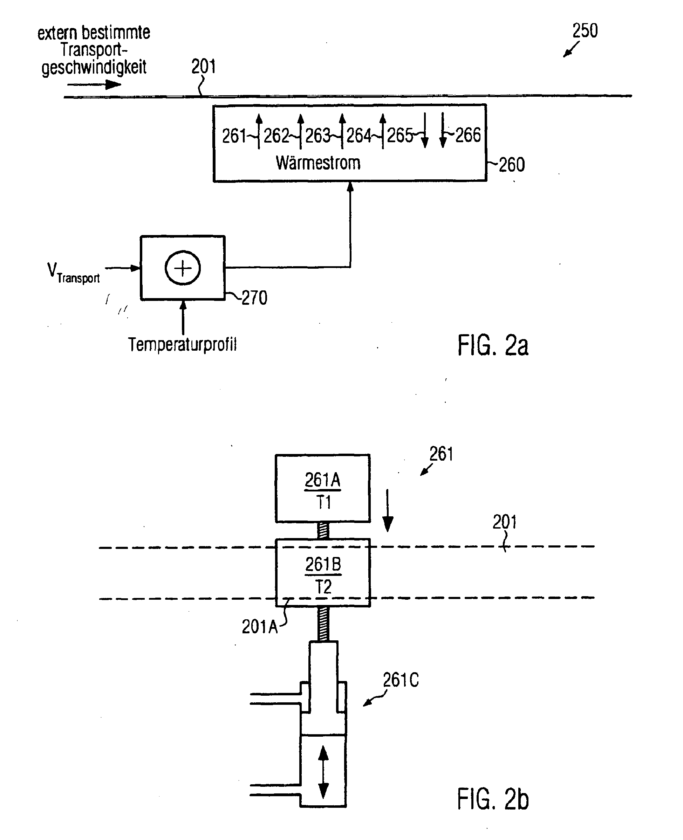

Fig. 2a zeigt schematisch eine Reflow-Löteinrichtung 250, in der ein kontinuierliches Substrat 201 verarbeitet werden kann, das gemäß einer vorgegebenen Transportgeschwindigkeit durch eine Prozesszone 260 geführt wird. Das kontinuierliche Substrat 201 ist beispielsweise ein flexibles Bandmaterial, auf welchem entsprechende Substratabschnitte in Form von gedruckten Schaltungen in der Anlage 250 zu bearbeiten sind. Ferner umfasst die Lötanlage 250 eine Steuereinrichtung 270, die ausgebildet ist, entsprechende Daten zu empfangen, die die Transportgeschwindigkeit des kontinuierlichen Substrats 201 kennzeichnen. Ferner ist die Steuereinrichtung 270 ausgebildet, die thermodynamischen Bedingungen zur Bearbeitung des kontinuierlichen Substrats 201 in der Prozesszone 260 in geeigneter Weise mit der vorgegebenen Transportgeschwindigkeit zu verknüpfen, um damit in der Prozesszone 260 ein gewünschtes Prozesstemperaturprofil und damit auch einen gewünschten Temperaturverlauf in den entsprechenden Abschnitten des kontinuierlichen Substrats 201 zu erzeugen.

In diesem Zusammenhang ist ein Prozesstemperaturprofil als eine Aneinanderreihung unterschiedlicher Prozesstemperaturen in Transportrichtung des Substrats 201 innerhalb der Prozesszone 260 zu verstehen. D.h., innerhalb der Prozesszone 260 sind Abschnitte mit unterschiedlicher Prozesstemperatur vorhanden, die sequentiell von den entsprechenden Substratabschnitten in dem Substrat 201 durchlaufen werden, um damit einen entsprechenden Wärmefluss von bzw. zum Substrat zu erzeugen. Die tatsächliche Temperatur des Substrats kann sich daher, abhängig von den entsprechenden Bedingungen in der Prozesszone 260, von der Prozesstemperatur unterscheiden. Beispielsweise kann während einer Vorheizphase ein entsprechender Substratabschnitt mit einer relativ hohen Prozesstemperatur beaufschlagt werden, die jedoch während der Einwirkdauer der entsprechenden Prozesstemperatur lediglich zu einem kontinuierlichen Anstieg der Substrattemperatur führt.

Erfindungsgemäß wird nun die entsprechende Einwirkdauer einer jeweiligen Prozesstemperatur in Abhängigkeit der vorgegebenen Transportgeschwindigkeit durch die Steuereinrichtung 270 so eingestellt, dass sich ein gewünschter Temperaturverlauf im jeweiligen Substratabschnitt ergibt, der für die Erzeugung der entsprechenden Lötverbindungen mit der erforderlichen hohen Qualität gewünscht ist. Zu diesem Zweck weist in der dargestellten Ausführungsform die Prozesszone 260 mehrere Heizbereiche 261, ..., 264, sowie mehrere Kühlbereiche 265, 266 auf, die somit in Transportrichtung des Substrats 201 entsprechende Abschnitte mit einer spezifizierten Prozesstemperatur repräsentieren. Beispielsweise können die einzelnen Heiz- und Kühlbereiche 261, ... , 266 entsprechende Wärmeleitoberflächen aufweisen, wie dies nachfolgend detaillierter beschrieben ist, die mit dem kontinuierlichen Substrat 201 in Kontakt gebracht werden, um damit zumindest einen Teil der für die Prozessierung des Substrats 201 erforderlichen Wärme zu übertragen. Die Abmessungen der einzelnen Bereiche 261, ..., 266 entspricht dabei im Wesentlichen der Größe eines Substratabschnitts, der in einer vorhergehenden Anlage bearbeitet wird, wenn eine getaktete Betriebsweise betrachtet wird. In diesem Falle wird nach jedem Transportvorgang ein definierter Abschnitt des Substrats 201 in der Prozesszone 260 weiter transportiert, so dass dieser dann mit der gewünschten Prozesstemperatur in einem nächsten Bereich beaufschlagt wird.

Vor oder während des Betriebs der Lötanlage 250 erhält die Steuereinrichtung 270 die erforderlichen Daten und ermittelt ein entsprechendes Ansteuermuster für die Prozesszone 260, um die gewünschte Prozesstemperaturprofilierung zu erreichen. Dabei kann ein entsprechendes Ansteuerschema bereits vor der eigentlichen Bearbeitung des Substrats 201 ermittelt werden und dann in geeigneter Form in der Einrichtung 270 abgelegt werden, die damit ein in Abhängigkeit der Transportgeschwindigkeit und des gewünschten Temperaturprofils erzeugtes Schaltschema während des Betriebs der Anlage 250 anwendet. In einigen Ausführungsformen werden die entsprechenden Prozesstemperaturen für die einzelnen Bereiche 261, ... , 266 in Abhängigkeit der Transportgeschwindigkeit festgelegt und dann mittels der Einrichtung 270 in der Prozesszone 260 realisiert, wobei im weiteren Betrieb diese festgelegte angepasste Temperaturprofilierung in der Zone 260 beibehalten wird, sofern keine Änderungen hinsichtlich der Transportgeschwindigkeit und/oder der Größe der entsprechenden Abschnitte in dem Substrat 201 auftreten. Auf diese Weise kann ein hohes Maß an Flexibilität bei der Anpassung der Anlage 250 an unterschiedliche Produktarten bewerkstelligt werden, ohne dass wesentliche Änderungen in der Prozesszone 260 erforderlich sind.

In anderen Ausführungsformen wird das Temperaturprofil in der Prozesszone 260 eingestellt, indem die Steuereinrichtung 270 einen oder mehrere der Bereiche 261 in geeigneter Weise ansteuert, um die effektive Prozesstemperatur in jedem dieser Bereiche in Abhängigkeit von der jeweiligen Transportgeschwindigkeit einzustellen. Beispielsweise kann dazu einer oder mehrere der Bereiche 261, ..., 266 während einer einzelnen Taktperiode mit unterschiedlichen Prozesstemperaturen betrieben werden, um damit eine mittlere Prozesstemperatur zu erreichen, die den thermodynamischen Erfordernissen des entsprechenden Produkts auf dem Substrat 201 angepasst ist. Eine entsprechende Betriebsweise ermöglicht ein rasches Reagieren auf mögliche Änderungen in Bearbeitungsprozessen vor der Anlage 250, da beispielsweise beim Auftreten eines Stillstands beim Transport des Substrats 201 die Steuereinrichtung 270 entsprechend reagieren kann, so dass keine Überhitzung der in der Anlage 250 vorhandenen Produkte auftritt. Auf diese Weise können kurzfristig auftretende Störungen berücksichtigt werden, ohne dass es zu nennenswerten Ausbeuteverlusten kommt.

Fig. 2b zeigt schematisch einen der Bereiche 261, ..., 266 der Prozesszone 260 gemäß einer anschaulichen Ausführungsform, wobei in diesem Beispiel der Bereich 261 gezeigt ist, der eine erste Wärmeleitoberfläche 261 a und eine zweite Wärmeleitoberfläche 261b aufweist. Die Wärmeleitoberflächen 261a und 261b sind mit einer Antriebseinrichtung 261 c gekoppelt, die in der gezeigten Ausführungsform eine Bewegung der beiden Flächen 261a, 261b in einer zu der von dem Substrat 201 definierten Ebene parallelen Ebene ermöglicht. In der gezeigten Ausführungsform können beispielsweise die Wärmeleitoberflächen 261a, 261b beide mechanisch miteinander gekoppelt sein, so dass durch eine entsprechende Bewegung der Einrichtung 261 c eine der beiden Wärmeleitoberflächen mit einem entsprechenden Substratabschnitt 201 in Kontakt gebracht wird. Die Wärmeleitoberflächen 261a, 261b können jedoch auch mit der Antriebseinrichtung 261c so verbunden sein, dass eine individuelle und unabhängige Bewegung der jeweiligen Wärmeleitoberflächen möglich ist, wie dies nachfolgend beschrieben ist. In der dargestellten Ausführungsform können die jeweiligen Wärmeleitoberflächen 261a, 261b mit entsprechenden Prozesstemperaturen T1, T2 betrieben werden, so dass der entsprechenden Abschnitt 201 a des Substrats 201 nach Bedarf mit zwei unterschiedlichen Prozesstemperaturen beaufschlagt werden kann, um damit eine gewünschte effektive Temperatur im Substratabschnitt zu erreichen. Wenn beispielsweise der Bereich 261 eine Vorheizzone repräsentiert, kann die Prozesstemperatur T2, die aktuell auf einen entsprechenden Substratabschnitt 201 a einwirkt, eine typische geeignete Prozesstemperatur, beispielsweise 150 Grad Celsius oder dgl., repräsentieren, die z.B. für eine gewisse Verweildauer des Substratabschnitts 201 bei dieser Temperatur ausgelegt ist. Wenn die extern vorgegebene Transportgeschwindigkeit jedoch eine längere Verweildauer des entsprechenden Abschnitts 201a des Substrats 201 erfordert, kann in dem Bereich 261 in gesteuerter Weise die effektive Einwirkdauer mit der Prozesstemperatur T2 angepasst werden, indem durch Aktivierung der Transporteinrichtung 261c die Wärmeleitoberfläche 261a mit dem entsprechenden Abschnitt 201 a in Kontakt gebracht wird. Die Prozesstemperatur T1 ist dabei eine niedrigere Prozesstemperatur, wie sie beispielsweise speziell für die Wärmeleitoberfläche 261a erzeugt wird oder die in anderen Bereichen der Prozesszone 260 verwendet wird, so dass kein zusätzlicher Aufwand bei der Erzeugung der Temperatur T1 erforderlich ist. Beispielsweise kann die Prozesstemperatur T1 auch die Umgebungstemperatur repräsentieren, beispielsweise die Substrattemperatur vor dem Eintreffen in der Prozesszone 260, so dass die zeitweilige Beaufschlagung mit der Prozesstemperatur T2 und T1 zu einer gemittelten Einwirkdauer der Vorheizdauer T2 führt, so dass sich damit in der mittleren Wirkung ein an die Transportgeschwindigkeit angepasstes Prozesstemperaturprofil ergibt, das dann unabhängig von der Transportgeschwindigkeit zu einem gewünschten Temperaturverlauf in dem Substratabschnitt führt. Selbstverständlich können auch andere Temperaturen für die Temperatur T1 eingestellt werden, beispielsweise kann eine deutlich geringere Temperaturdifferenz vorgesehen werden, um z.B. größere Temperaturgradienten zu vermeiden. Eine temporäre Beaufschlagung mit der Vorheiztemperatur T2 und mit der "neutralen" Temperatur T1 kann in einer beliebigen Weise erfolgen, so kann beispielsweise zunächst eine Beaufschlagung mit der Temperatur T2 folgen, und in einer abschließenden Phase kann die Prozesstemperatur T1 angewendet werden, um damit insgesamt eine gewünschte Einwirkdauer mit der Temperatur T2 zu erreichen. Selbstverständlich können auch andere zeitliche Abfolgen angewendet werden, beispielsweise können die Wärmeleitoberflächen 261a, 261b in abwechselnder Weise mehrere Male mit dem Substrat 201 in Kontakt gebracht werden, so dass sich insgesamt die gewünschte Einwirkdauer ergibt.

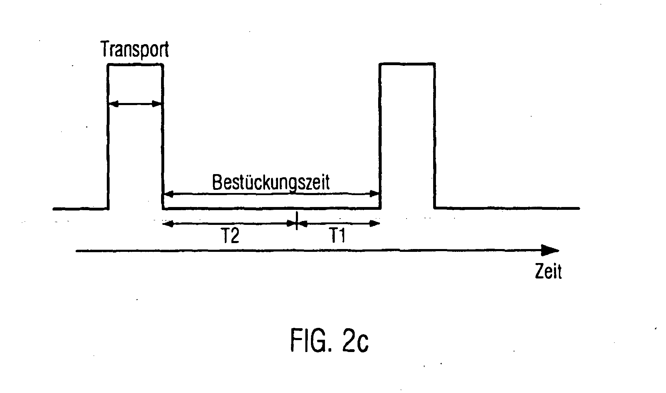

Fig. 2c zeigt schematisch eine typische Betriebsweise der Anlage 250, wenn diese entsprechend einem extern vorgegebenen Takt mit Substratabschnitten 201 a des kontinuierlichen Substrats 201 beschickt wird. In Fig. 2c sind entsprechende Transportaktivitäten dargestellt, die eine gewisse Zeitspanne in Anspruch nehmen, um einen Substratabschnitt 201a bzw. ein Image, weiterzutransportieren. Beispielsweise kann eine Transportaktivität eine oder mehrere Sekunden benötigen. Zwischen zwei Transportaktivitäten ergibt sich eine Phase, in der ein jeweiliger Substratabschnitt 201 a in der Prozesszone 260 in Ruhe ist, so dass damit eine Beaufschlagung mit einer gewünschten Prozesstemperatur erfolgt. Beispielsweise sei angenommen, dass die entsprechende Phase durch die Bestückungszeit bestimmt ist, die für das Aufbringen entsprechender elektronischer Komponenten auf einen entsprechenden Substratabschnitt 201 a erforderlich ist. In dieser als Taktdauer bezeichneten Phase wird beispielsweise ein entsprechender Substratabschnitt 201 a in den ersten Bereich 261 transportiert und kann dort mit den entsprechenden Prozesstemperaturen T2 und T1 beaufschlagt werden. In der gezeigten Ausführungsform wird beispielsweise zunächst der Substratabschnitt 201 a mit der Wärmeleitoberfläche 261 b in Kontakt gebracht und nach einer von der Steuereinrichtung 270 ermittelten Zeitdauer wird die Wärmeleitoberfläche 261 a mit dem Substratabschnitt in Kontakt gebracht, so dass sich auf dem Abschnitt 201 a eine geeignete Temperatur ausbildet. Auf diese Weise kann beispielsweise die Vorheizdauer in diesem Takt durch das Beaufschlagen mit T1 in geeigneter Weise verkürzt werden, so dass auch bei längeren Bestückungszeiten ein den thermodynamischen Erfordernissen angepasster Temperaturverlauf in dem jeweiligen Substratabschnitt 201 a erreicht wird.

In ähnlicher Weise können auch die weiteren Bereiche 262, ..., 266 angesteuert werden, um auch dort die effektive Einwirkdauer einer gewünschten Prozesstemperatur in Abhängigkeit der Transportgeschwindigkeit einzustellen. Wenn beispielsweise der Bereich 261 eine Lötzone repräsentiert, in der die Temperatur der Lotpaste nach einem vorangehenden Vorheizen in gesteuerter Weise über die Schmelztemperatur erwärmt werden soll, kann eine Prozesstemperatur, beispielsweise die Temperatur T2 die gewünschte Löttemperatur repräsentieren, während die Temperatur T1 eine geeignete Abkühltemperatur repräsentieren kann, so dass auch für längere Bestückungszeiten eine definierte Verflüssigung der Lotpaste gewährleistet ist und anschließend eine definierte Abkühlung entsprechend dem gewünschten Temperaturverlauf gewährleistet ist, so dass die Qualität der erzeugten Lötverbindungen vergleichbar ist zu einem Prozess, in welchem die Verweildauer in jeweiligen Prozesszonen nur durch die thermodynamischen Erfordernisse und nicht durch eine Transportgeschwindigkeit vorgegeben ist.

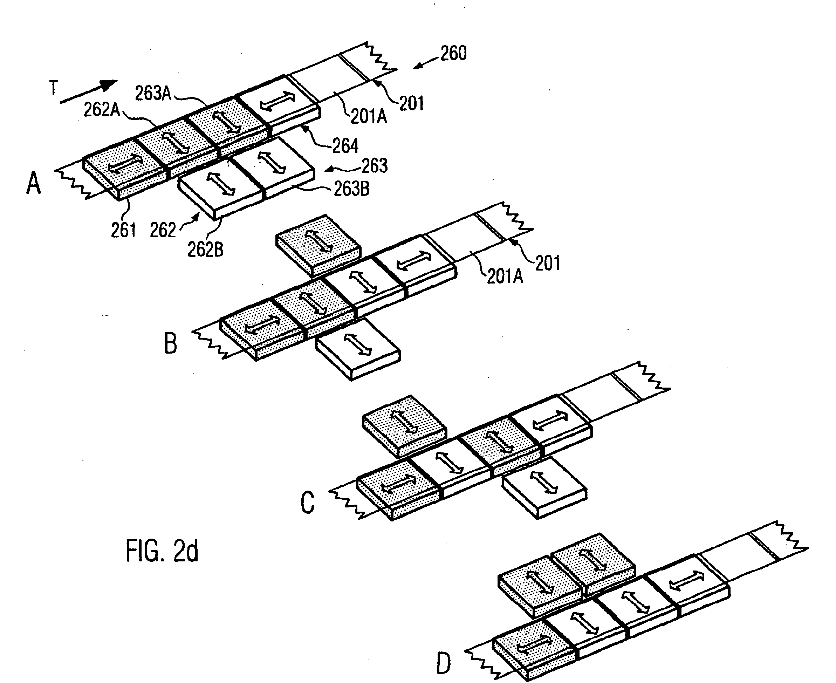

Fig. 2d zeigt schematisch die Prozesszone 260 in unterschiedlichen Konfigurationen gemäß einer weiteren anschaulichen Ausführungsform. Hier sind entsprechend Bereiche 261, 262, 263 und 264 vorgesehen, die Wärmeleitoberflächen aufweisen, die horizontal bzw. parallel zu einer auf das Substrat 201 definierten Ebene bewegbar sind. In der gezeigten Ausführungsform können die einzelnen Wärmeleitoberflächen individuell bewegbar sein, es können eine oder mehrere Wärmeleitoberflächen in Form gekoppelter Abschnitte vorgesehen werden, etwa in Form von Abschnitten 262b, 262a, 263b, 263a, so dass gegebenenfalls der Aufbau entsprechender Antriebseinrichtungen (nicht gezeigt) vereinfacht werden kann. In der gezeigten Ausführungsform ist beispielsweise eine Bewegung der Wärmeleitoberflächen der Bereiche 261 und 264 bei Bedarf in Transportrichtung vorgesehen, während die Wärmeleitoberflächen 262a, 262b, 263a, 263b der Bereiche 262 und 263 quer zur Transportrichtung verschiebbar sind. Beispielsweise können die Wärmeleitoberflächen 261, 262a und 263a Heizplatten repräsentieren, während die Wärmeleitoberfläche 264 eine Kühlplatte repräsentiert und die entsprechenden Oberflächen 262b, 263b ebenfalls Kühlplatten repräsentieren oder eine andere geeignete Prozesstemperatur repräsentieren, die in Verbindung mit den jeweiligen Heiztemperaturen eine geeignete Profilierung des Gesamtprozesstemperaturprofils ermöglichen.

Die einzelnen Wärmeleitoberflächen werden durch geeignete Heizquellen auf der gewünschten Prozesstemperatur gehalten, wobei beliebige Wärmequellen eingesetzt werden können, etwa Widerstände, Strahlungsquellen, Konvektion eines Fluid, Peltier-Elemente, Direktverdampfungsmechanismen, und dgl., abhängig davon, ob eine effiziente Aufheizung oder Kühlung gewünscht ist. Die Größe der wirksamen Oberfläche der einzelnen Wärmeleitoberflächen ist auf die Größe eines entsprechenden Abschnitts 201 a auf dem Substrat 201 angepasst, der somit der während einer Transportaktivität zurückgelegten Strecke entspricht. In der Regel entspricht somit jedem Abschnitt 201 a eine entsprechende gedruckte Schaltung oder mehrere gedruckte Schaltungen, die während eines einzelnen Arbeitsganges zusammen bearbeitet werden.

Somit liegen während des Betriebs der Anlage 250 gemäß der Konfiguration A entsprechende Abschnitte 201 a auf entsprechenden Wärmeleitoberflächen, in dem gezeigten Falle auf den Wärmeleitoberflächen 261, 262a, 263a und 264. Beispielsweise können die Wärmeleitoberflächen 261 und 262a als Heizfelder für die Vorheizung entsprechender Abschnitte 201 a betrachtet werden, während die Wärmeleitoberfläche 263a eine Lötzone repräsentiert, in der die Lotpaste tatsächlich aufgeschmolzen wird, woran sich eine Kühlfläche in Form der Wärmeleitoberfläche 264 anschließt. Wenn die Transportgeschwindigkeit für das Band 201 längere Verweilzeiten auf den entsprechenden Wärmeleitoberflächen verlangt und diese längeren Verweilzeiten nicht mit den thermodynamischen Erfordernissen für den Reflow-Lötvorgang im Einklang sind, kann, wie zuvor dargelegt ist, eine entsprechende Beaufschlagung einer oder mehrerer der Wärmeleitoberflächen mit einer anderen Prozesstemperatur durchgeführt werden, um die effektive Einwirkdauer in geeigneter Weise zu steuern.

Z.B. zeigt die Konfiguration B die Prozesszone 260 in einer geänderten Situation, wobei beispielsweise nach einer gewünschten Verweildauer in der die Lötzone repräsentierenden Wärmeleitoberfläche 263a diese durch die Wärmeleitoberfläche 263b ersetzt wird, die eine geringere Temperatur aufweist, so dass eine effiziente Abkühlung des entsprechenden Substratabschnitts 201 a eintritt, bevor die nächste Transportaktivität den entsprechenden Abschnitt 201 a zu der weiteren Kühlfläche 264 weiterführt.

Die Konfiguration C zeigt beispielsweise eine Situation, in der die Vorheizdauer, die durch die Wärmeleitoberflächen 261 und 262a mit den jeweiligen Prozesstemperaturen eingestellt wird, für den entsprechenden Transporttakt zu lang ist, so dass nach einer gewünschten Einwirkzeit die Wärmeleitoberfläche 262a durch die Wärmeleitoberfläche 262b ersetzt wird, so dass vor dem Weitertransport zur eigentlichen Lötzone 263a eine geeignete Vorheiztemperatur erreicht wird. In der gezeigten Ausführungsform kann beispielsweise die Vorheizdauer variiert werden von einem Taktzyklus bis maximal zwei Taktzyklen, wobei eine nahezu kontinuierliche Einstellung zwischen diesen beiden Extremwerten durch das Einstellen einer gewünschten Verweildauer der entsprechenden Wärmeleitoberflächen 262a, 262b erreicht werden kann.

In der Konfiguration D ist eine Situation gezeigt, in der beispielsweise die Vorheizphase für einen Abschnitt 201a entsprechend gesteuert wird, indem die Wärmeleitoberfläche 262a durch die Wärmeleitoberfläche 262b ersetzt wird, wobei auch für einen davor liegenden Abschnitt die jeweilige Lötzeit durch Ersetzen der Wärmeleitoberfläche 263a durch die Oberfläche 263b in geeigneter Weise eingestellt wird. Zu beachten ist, dass die jeweilige Einstellung individuell erfolgen kann, so dass sich für das Vorheizen und das Löten individuell einstellbare Einwirkdauern erreichen lassen. Selbstverständlich können die entsprechenden Wärmeleitoberflächen in einer beliebigen Art und Weise zeitlich gegeneinander ausgetauscht werden, wie dies zuvor auch in Zusammenhang mit der Fig. 2b und 2c erläutert ist, um damit eine gewünschte effektive Temperatursteuerung zu erreichen. Im Falle einer Lötheizzone, etwa der Zone 263a, wird jedoch in der Regel eine Beaufschlagung mit der gewünschten Prozesstemperatur erfolgen und nach Ablauf einer gewünschten Zeitdauer kann dann eine Abkühlung durch Ersetzen der Oberfläche 263a durch die Oberfläche 263b erfolgen. Wenn die entsprechende Prozesstemperatur 263b aufgrund einer baulichen Beschränkung der entsprechenden Wärmequellen als zu gering erachtet wird, so dass gegebenenfalls eine zu schnelle Abkühlung hervorgerufen wird, kann auch ein getakteter abwechselnder Austausch, zumindest phasenweise nach dem erfolgten Lötvorgang ausgeführt werden, um eine höhere mittlere Abkühltemperatur zu erreichen, bevor die eigentliche Kühlfläche 264 verwendet wird.

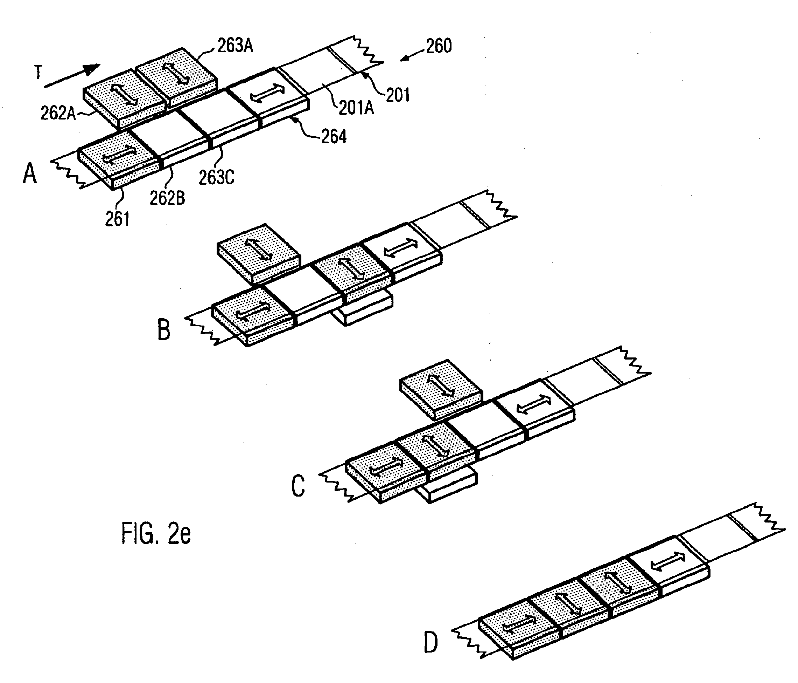

Fig. 2e zeigt schematisch die Prozesszone 260 in vier verschiedenen Betriebszuständen A, B, C, D gemäß weiterer anschaulicher Ausführungsformen. In diesen Ausführungsformen sind einige der Wärmeleitoberflächen im Wesentlichen senkrecht zu der durch das Substrat 201 definierten Ebene verschiebbar, etwa die als Kühlflächen dienenden Elemente 262b, 263c, während andere Wärmeleitoberflächen, etwa die Wärmeleitoberflächen 262a, 263a parallel zur Ebene verschiebbar sind. Im Betriebszustand B ist beispielsweise die Wärmeleitoberfläche 263c abgesenkt und durch die parallel verschiebbare Wärmeleitoberfläche 263a ersetzt, während beispielsweise in der Betriebsphase C die Vorheizfläche 262a die nach unten abgesenkte Kühlfläche 262b ersetzt. In der Betriebsphase D sind beide Kühlflächen 262b, 263c durch die jeweiligen heizenden Wärmeleitoberflächen 262a, 263a ersetzt. Aufgrund der im Wesentlichen senkrecht zueinander ausgerichteten Verschiebungsrichtungen der jeweiligen Wärmeleitoberflächen 262a, 263a, 262b, 263c kann eine deutliche Verringerung der lateralen Abmessungen der Prozesszone 260 und damit auch einer entsprechenden Installationsgröße der gesamten Reflow-Lötanlage 250 erreicht werden. In dem gezeigten Beispiel ergibt sich eine Reduzierung der lateralen Abmessungen im Vergleich zu der in Fig. 2D gezeigten Ausführungsform von etwa einem Drittel.

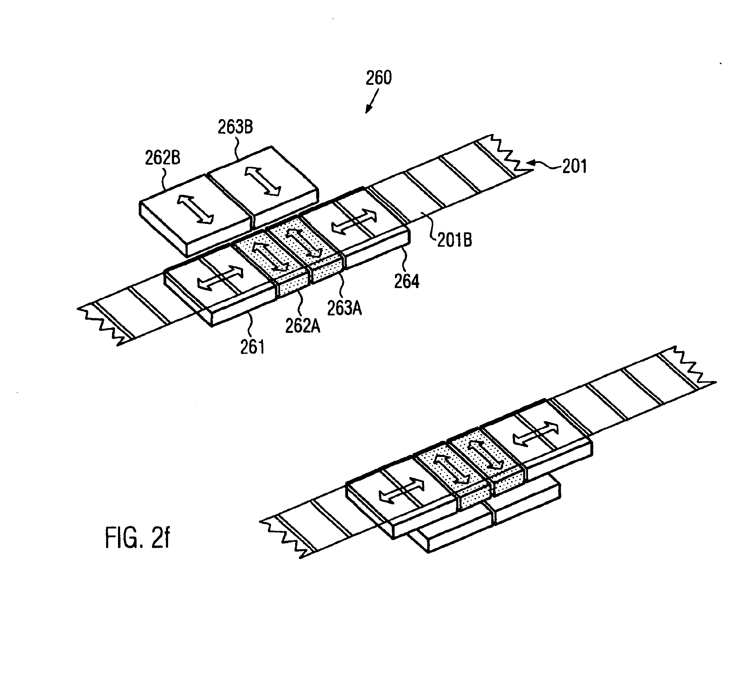

Fig. 2f zeigt schematisch die Prozesszone 260 gemäß einer weiteren anschaulichen Ausführungsform. In dieser Ausführungsform sind zumindest einige der Wärmeleitoberflächen, etwa die als Heizfläche dienenden Oberflächen 262a, 263a als austauschbare Elemente vorgesehen, die im Wesentlichen der Größe eines entsprechenden Abschnitts 201 b, der in der gezeigten Ausführungsform etwa die Hälfte der Größe in Längsrichtung des Abschnitts 201 a aufweist, anpassbar: Beispielsweise können die entsprechenden Elemente aus Fig. 2d oder 2f durch die kleineren Elemente 262a, 263a der Fig. 2f ersetzt werden. Ferner können bei Bedarf auch die entsprechenden weiteren Wärmeleitoberflächen mit einer angepassten Größe bereitgestellt werden. In der gezeigten Ausführungsform werden die Kühlflächen 261, 264, 262b und 263b beibehalten, wobei zur Anpassung die Wärmeleitoberflächen 261 und 264 in und entgegen der Transportrichtung verschiebbar sind. Beispielsweise kann, wenn eine Verkürzung der effektiven Vorheizdauer gewünscht ist, die durch die Wärmeleitoberfläche 262a vermittelt wird, die Oberfläche 261 entgegen der Transportrichtung verschoben werden und die Wärmeleitfläche 262a wird quer zur Transportrichtung nach rechts herausgeführt und der freiwerdende Raum wird durch die Wärmeleitoberfläche 262b eingenommen, so dass ein entsprechender Abschnitt 201 b, der zuvor durch die Wärmeleitfläche 262a beaufschlagt wurde, nunmehr mit der tieferen Temperatur der Kühlfläche 262b beaufschlagt wird. In ähnlicher Weise kann die Lötphase den vorgegebenen Taktzeiten angepasst werden, indem die Wärmeleitoberfläche 264 in Transportrichtung verschoben wird und die Oberfläche 263a in Transportrichtung nach rechts herausgeführt wird, wobei dann der entsprechende Bereich, der in diesem Falle zwei Abschnitten 201 b entspricht, von der Oberfläche 263b beaufschlagt wird.

Im unteren Teil der Fig. 2f ist die Lötzone 260 gemäß einer weitere Ausführungsform dargestellt, in der die entsprechenden Kühlflächen 262b, 263b senkrecht zur Ebene der Substratabschnitte 201b, d.h. in diesem Falle vertikal, verschiebbar sind. Durch Verschieben der entsprechenden Wärmeleitoberflächen 261, 262a, 263a und 264 in der zuvor beschriebenen Weise kann dann durch eine vertikale Verschiebung der Flächen 262b, 263b eine gesteuerte Profilierung bewerkstelligt werden, wobei in diesem Falle eine geringere laterale Abmessung für die Prozesszone 260 erreicht wird. Somit kann durch das Vorsehen entsprechend dimensionierter Wärmeleitoberflächen, etwa der Oberflächen 262a, 263a eine effiziente Anpassung an die Größe der Abschnitte 201 a, 201b erfolgen, indem diese Abschnitte bei Änderung der Größe der Abschnitte 201a, 201b geeignet ausgetauscht werden. Dabei können die gleichen Antriebseinrichtungen verwendet werden, so dass kein weiterer Aufwand bei der Anpassung der Prozesszonengröße an die Größe der einzelnen Abschnitte auf dem Substrat 201 erforderlich ist.

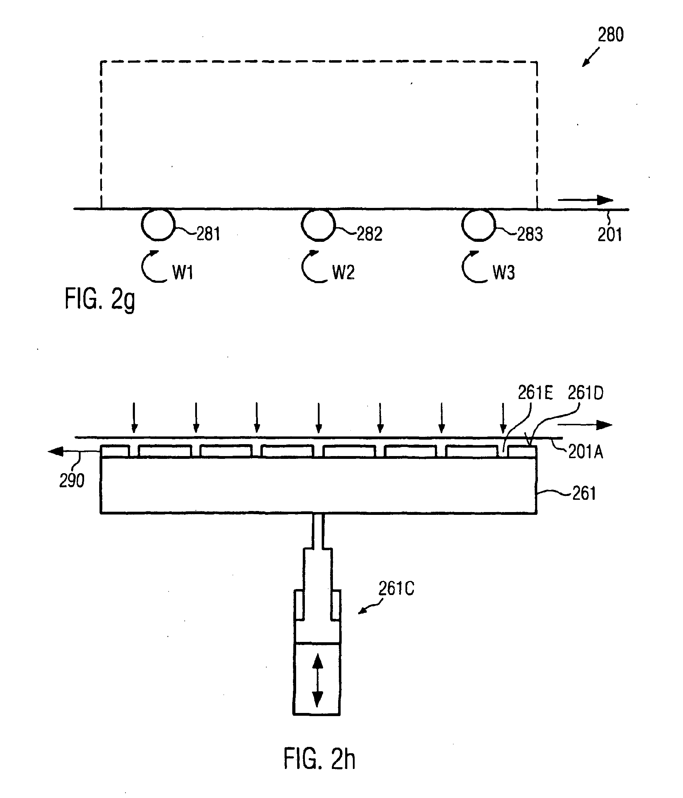

Fig. 2g zeigt schematisch eine Spanneinrichtung 280, die der Reflow-Lötanlage 250 vorgeordnet oder nachgeordnet sein kann oder die ein integraler Bestandteil der Anlage 250 sein kann. Die Spannvorrichtung 280 ist dabei so ausgebildet, dass ein flexibles Substratband in geeigneter Weise gespannt werden kann, so dass zumindest in der Prozesszone 260 der Anlage 250 das Auftreten von Verwindungen oder Wölbungen in dem Substratband 201 im Wesentlichen vermieden wird. Auf diese Weise kann der Kontakt zu den entsprechenden Wärmeleitoberflächen verbessert werden, so dass sich insgesamt eine gleichmäßigere Temperaturverteilung auf den entsprechenden Substratabschnitten ergibt. Zum Beispiel kann die Spanneinrichtung 280 geeignete Antriebsmittel 281, 282, 283 aufweisen, die durch mechanischen Kontakt mit dem Band 201 eine Straffung herbeiführen. In dem gezeigten Ausführungsbeispiel können entsprechende Rollen vorgesehen sein, die sich während eines Transportvorgangs mit geringfügig unterschiedlichen Geschwindigkeiten w1, w2, w3 drehen, so dass durch die höheren Geschwindigkeiten w2 und w3 im Vergleich zu w1 ein Spannen des Bandes 201 zumindest innerhalb des Bereichs der Rollen 281, 282 und 283 erreicht wird. Beispielsweise kann die Spannvorrichtung 280 innerhalb der Prozesszone 260 vorgesehen sein, so dass dort zuverlässig entsprechende Verwindungen und Wölbungen vermieden werden. In anderen Ausführungsformen können andere mechanische Einrichtungen, die im Stand der Technik bekannt sind, eingesetzt werden, um eine entsprechende Straffung des flexiblen Bandes 201 zumindest innerhalb der Prozesszone 260 zu erreichen.

Fig. 2h zeigt schematisch eine Wärmeleitoberfläche, beispielsweise die Wärmeleitoberfläche 261, die mit einer entsprechenden Antriebseinrichtung, etwa der Einrichtung 261 c gekoppelt ist, die für eine vertikale Verschiebung der Wärmeleitoberfläche 261 ausgebildet ist. Die Wärmeleitoberfläche 261, die als eine Materialschicht zu verstehen ist, besitzt eine thermisch wirksame Oberfläche 261 d, die mit einem Substratabschnitt 201a in Kontakt gebracht wird, um damit die Prozesstemperatur, die in der Wärmeleitoberfläche 261 eingestellt ist, auf den Abschnitt 201 a einwirken zu lassen. In den zuvor mit Bezug zu den Fig. 2d bis 2f gezeigten Ausführungsformen findet zum Teil eine parallel zum Substrat 201 gerichtete Bewegung statt, so dass die Oberfläche 261 d zumindest teilweise entlang dem Substrat 201 gleitet. Die guten Gleiteigenschaften der Oberfläche 261 d werden eingestellt, indem eine entsprechende Oberfläche der Wärmeleitoberfläche 261 in geeigneter Weise bearbeitet wird, beispielsweise poliert wird, um damit den Gleitreibungskoeffizienten in Bezug auf das Material des Substrats 201 zu verringern, und/oder indem eine geeignete Materialzusammensetzung auf die Wärmeleitoberfläche 261 aufgebracht wird, die die guten Gleiteigenschaften und damit den geringen Gleitreibungskoeffizienten ergibt. Beispielsweise können Materialien wie Teflon, Grafit und dergleichen verwendet werden, um die Oberfläche 261 d mit den gewünschten Gleiteigenschaften zu schaffen. Ferner kann eine entsprechende Form eines Randes der Oberfläche 261 d so gestaltet werden, dass ein geringer Widerstand auftritt, wenn die entsprechende Oberfläche 261 d durch paralleles Bewegen mit dem Substratband 201 in Kontakt gebracht wird. Z.B. kann eine entsprechende Verrundung vorgesehen werden, so dass bei seitlichem Auftreffen auf das Substrat 201 nur ein geringer mechanischer Widerstand auftritt. Bei einer im Wesentlichen vertikalen Bewegung der Wärmeleitoberfläche 261, wie dies beispielsweise in Fig. 2h gezeigt ist, sind die entsprechenden Gleiteigenschaften der Oberfläche 261 d weniger relevant.

In einer weiteren Ausführungsform ist die Oberfläche 261 d in geeigneter Weise ausgebildet, um Hohlräume oder Aussparungen 261 e vorzusehen, die mit einer geeigneten Fluidquelle, etwa einer Vakuumpumpe, einer Druckquelle, und dgl. 290 in Verbindung stehen. Die entsprechenden Aussparungen 261 e können beispielsweise in Form von Perforationen in der Oberfläche 261 d oder entsprechende Kanäle vorgesehen werden, die strömungsmäßig mit der Quelle 290 in Verbindung gebracht werden können. Auch kann die Oberfläche 261d aus einem porösen Material hergestellt werden, wobei ein Fluidkontakt mit der Quelle 290 hergestellt wird, so dass entsprechende Druckverhältnisse in dem porösen Material 261 d geschaffen werden können. Aufgrund dieser Aussparungen 261 e kann beispielsweise ein Unterdruck bzw. Vakuum angelegt werden, so dass das Band 201 zur Oberfläche 261d hin angesaugt wird, um damit den Kontakt und die thermische Kopplung während des Aufliegens auf der Oberfläche 261 d zu verbessern. Dabei kann die entsprechende Fluidquelle 290 in geeigneter Weise schaltbar sein, so dass beispielsweise der Unterdruck aufgehoben wird, wenn ein entsprechender Transportvorgang stattfindet und wenn innerhalb einer entsprechenden Ruhephase des Substrats 201 eine Verschiebung der Wärmeleitoberfläche 261 stattfinden soll. Beispielsweise kann unmittelbar vor dem Verschieben der Wärmeleitoberfläche 261 in horizontaler Richtung oder vertikaler Richtung, wie dies zuvor erläutert ist, die Fluidquelle 290 so angesteuert werden, dass die Aussparungen 261 e mit Normaldruck oder leichtem Überdruck beaufschlagt werden, so dass die Haftung der Oberfläche 261d an dem Substrat 201 im Wesentlichen aufgehoben wird oder sogar ein gewisser Luftfilm erzeugt wird, um damit entsprechende Gleiteigenschaften zu erzeugen. Auf diese Weise kann eine gute Gleitfähigkeit während des Verschiebens der Wärmeleitoberfläche 261 erreicht werden, ohne dass spezielle Materialien oder eine spezielle Bearbeitung der Fläche 261d erforderlich sind. Somit können die Materialeigenschaften der Oberfläche 261d im Hinblick auf eine effiziente Wärmeübertragung und - verteilung ausgewählt werden, ohne dass die Gleiteigenschaften zu berücksichtigen sind.

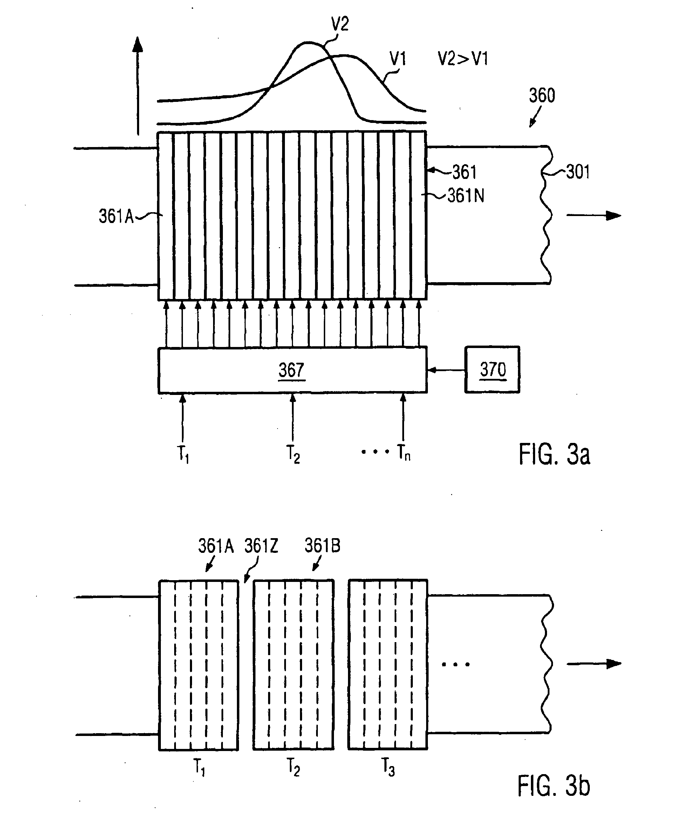

Fig. 3a zeigt eine Prozesszone 360 gemäß weiterer anschaulicher Ausführungsformen, in denen eine Wärmeleitoberfläche 361 mehrere Abschnitte 361a, ..., 361 n aufweist, die zumindest in Transportrichtung eines Substratbandes 301 eine geringere Größe aufweisen als typischerweise verwendete laterale Abmessungen von auf dem Band 301 herzustellenden Schaltungen. Zumindest einige der Abschnitte 361a, ..., 361n sind mit einer Schalteinrichtung 367 in Verbindung, die ausgebildet ist, zwei oder mehr Prozesstemperaturen T1, ..., Tn in ausgewählten Abschnitten einzustellen. Dazu kann die Schalteinrichtung 367 mit einer entsprechenden Steuereinrichtung 370 verbunden sein, die in ähnlicher Weise aufgebaut ist, wie die Steuereinrichtung 270 und somit auf der Grundlage einer Transportgeschwindigkeit für das Band 301 eine geeignete Temperaturprofilierung für die Wärmeleitoberfläche 361 erzeugen kann. Beispielsweise kann für eine gegebene Größe der entsprechenden Abschnitte auf dem Band 301 in Transportrichtung eine geeignete Anzahl an Abschnitten 361 a, ..., 361 n zu einer effektiven Wärmeleitoberfläche zusammengestellt werden, so dass dann die entsprechenden Abschnitte mit einer gewünschten Prozesstemperatur betrieben werden. Entsprechend aufeinander folgende Gruppen aus jeweiligen Abschnitten 361a, ..., 361n können dann mit entsprechenden angepassten Prozesstemperaturen beaufschlagt werden, so dass insgesamt in Abhängigkeit der auftretenden Transportgeschwindigkeiten ein geeigneter Temperaturverlauf in den jeweiligen Substratabschnitten erreicht wird. Somit lässt sich eine geeignete Anpassung der Prozesszone 360 erreichen, ohne dass Änderungen am mechanischen Aufbau der Prozesszone 360 erforderlich sind.

In anderen anschaulichen Ausführungsformen sind die jeweiligen Abschnitte 361a, ..., 361n so beschaffen, dass sie zeitlich sequentiell mit unterschiedlichen Prozesstemperaturen T1, ..., Tn betrieben werden können, so dass zusätzlich zur jeweiligen effektiven Länge einzelner Wärmeleitabschnitte auch deren effektive Temperatur variierbar ist, wie dies auch zuvor mit den bewegbaren Wärmeleitoberflächen beschrieben ist. Zu diesem Zweck kann die Schalteinrichtung 367 in Verbindung mit den Abschnitten 361 a, ..., 361 n ausgebildet sein, nach einer kurzen Einschwingphase entsprechend unterschiedliche Prozesstemperaturen in jedem der Abschnitte 361a, ..., 361 n zu erzeugen. Zu diesem Zweck können entsprechende Heizeinrichtungen, beispielsweise in Form von Widerstandsheizungen, Peltier-Elementen, Fluide, und dgl. verwendet werden, die von der Schalteinrichtung 367 in geeigneter Weise angesteuert werden, um damit in den Abschnitten 361a, ..., 361 n die gewünschte Prozesstemperatur kurzfristig hervorzurufen. Zum Beispiel kann ein Prozessfluid mit einer gegebenen Prozesstemperatur T1 mittels entsprechender gesteuerter Ventilelemente aus einem Reservoir ausgewählten Abschnitten für eine gewisse Zeitdauer zugeführt werden, so dass für eine gewünschte Zeitdauer die jeweilige Prozesstemperatur an dem Substratabschnitt anliegt. Nach einer entsprechenden Einwirkdauer kann die Schalteinrichtung 367 die Zufuhr dieses Prozessfluids unterbrechen und kann die Zufuhr eines anderen Prozessfluids mit einer unterschiedlichen Prozesstemperatur bewirken, so dass damit eine andere Temperatur auf den jeweiligen Substratabschnitt einwirkt. Dazu können die jeweiligen Abschnitte 361 a, ..., 361 n so aufgebaut sein, dass ihre Wärmekapazität relativ gering ist und die jeweilige wirksame Oberfläche ein hohes Wärmeleitvermögen aufweist, so dass sich die unterschiedlichen Prozesstemperaturen in kurzen Zeiten etwa weniger als einer Sekunde bis einige Sekunden einstellen. Auf diese Weise können somit gut definierte unterschiedliche Prozesstemperaturen an den jeweiligen Substratabschnitt angelegt werden, wobei die Feinstruktur der Wärmeleitoberfläche 361 auch eine entsprechende Anpassung an die Größe der jeweiligen Substratabschnitte ermöglicht.

In anderen Ausführungsformen können elektrisch betriebene Heiz- oder Kühleinrichtungen verwendet werden, so dass die Schalteinrichtung 367 durch elektronische Schaltungen verwirklicht werden kann, um damit die gewünschten Prozesstemperaturen bereitzustellen. Beispielsweise können Peltier-Elemente durch Umschalten der Stromrichtung in ihrer Wirkung invertiert werden, so dass diese zum Heizen und zum Kühlen verwendet werden können, wobei beispielsweise eine von der Oberfläche der Elemente 361a, ..., 361n abgewandten Oberfläche mit einem Fluid einer bestimmten Prozesstemperatur in Verbindung sein kann, so dass sich durch entsprechendes Beschalten der Peltier-Elemente eine gut definierte Differenz zu der entsprechenden Prozesstemperatur verwirklichen lässt. In anderen Ausführungsformen können Peltier-Elemente in Verbindung mit Widerstandselementen eingesetzt werden, so dass bei Funktion als Heizeinrichtung ein hoher thermischer Wirkungsgrad erreicht werden kann, während in der Funktion als Kühlung eine höhere elektrische Leistung gegebenenfalls nur über geringe Zeitdauer aufzuwenden ist.

Fig. 3b zeigt schematisch die Prozesszone 360, in der mehrere erste Abschnitte 361 a und mehrere zweite Abschnitte 361 b zu entsprechenden Wärmeleitoberflächen mit einer jeweiligen Prozesstemperatur T1 bzw. T2 "verschaltet" sind. Somit kann die Größe der entsprechenden Abschnitte 361a, 361b in der verschalteten Form auf die Größe der entsprechende Substratabschnitte eingestellt werden, ohne dass mechanische Änderungen in der Prozesszone 360 erforderlich sind, wobei entsprechend der Feinheit der individuellen Abschnitte 361a, ..., 361n auch geeignete Zwischenräume 361 z definiert werden können, um damit einen thermischen "Puffer" zwischen den beiden Prozesstemperaturen T1 und T2 vorzusehen. Des Weiteren können die einzelnen zusammengefassten Abschnitte 361a, 361 b jeweils mit unterschiedlichen Prozesstemperaturen beaufschlagt werden, so dass im Abschnitt 361a zur Temperatur T1 eine weitere Temperatur eingestellt werden kann, um damit der jeweiligen Verweildauer, die von der extern vorliegenden Transportgeschwindigkeit abhängt, Rechnung zu tragen, wie dies auch zuvor beschrieben ist. In anderen Ausführungsformen kann die Feinheit der individuellen Abschnitte 361a, ..., 361n so gewählt werden, dass nur einige Abschnitte mit einer ersten Prozesstemperatur betrieben werden und dennoch eine relativ gleichförmige Wärmeverteilung in dem Abschnitt 361a erreicht wird, während andere individuelle Abschnitte gleichzeitig oder zeitlich aufeinander folgend mit einer anderen Prozesstemperatur betrieben werden, um damit eine gewünschte mittlere Beaufschlagung entsprechend den Transportverhältnissen und den thermodynamischen Erfordernissen zu erreichen.

Es sollte beachtet werden, dass auch andere räumliche Unterteilungen durch entsprechende Formgebung der Abschnitte 361 a, ..., 361 n möglich sind, so dass bei Bedarf auch eine quer zur Transportrichtung erzeugte Unterteilung möglich ist, so dass insgesamt eine sehr feinfühlige Segmentierung der Prozesszone 360 möglich ist, so dass durch die Schalteinrichtung 367 relativ komplexe Schaltmuster zum Einstellen der gewünschten Temperatur auf den Substratabschnitten erzeugt werden können. Beispielsweise kann mit der Prozesszone 360 in effizienter Weise ein kontinuierlicher Transport des Bandes 301 verwirklicht werden, wobei eine angepasste Temperaturprofilierung durch das Beaufschlagen mit einem geeigneten Prozesstemperaturprofil in Längsrichtung durch die Variabilität sowohl in der räumlichen Erstreckung der wirksamen Oberfläche der Prozesszone 360 als auch durch eine mögliche Einstellung sehr unterschiedlicher Prozesstemperaturen in einzelnen Segmenten der Prozesszone 360 ermöglicht wird.

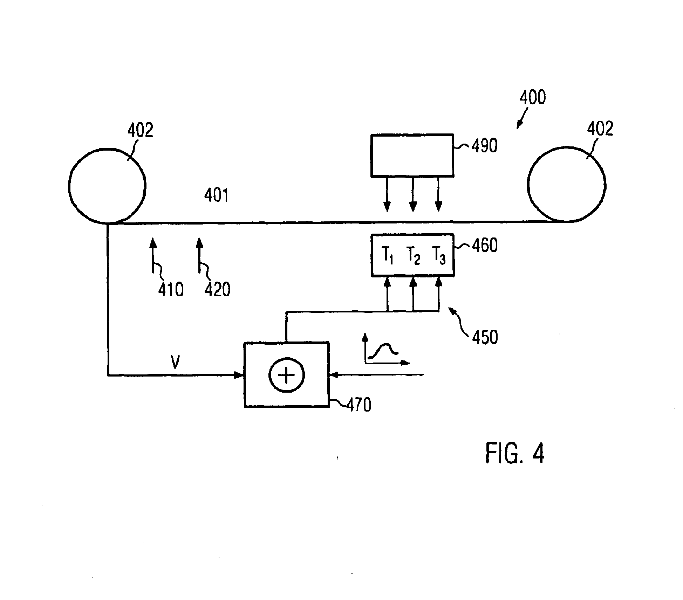

Fig. 4 zeigt schematisch ein System 400 zur Herstellung von gedruckten Schaltungen auf einem flexiblen Endlosband 401, das mittels eines Transportsystems 402 in Abhängigkeit von den Gegebenheiten entsprechender Bearbeitungsstationen 410 und 420 transportiert wird. Die Station 410 kann dabei eine Druckstation repräsentieren, die zum Aufdrucken einer Lotpaste ausgebildet ist, während die Station 420 eine Bestückungsstation repräsentiert, in der Komponenten auf entsprechende Substratbereiche automatisch aufgebracht werden. Ferner ist eine Lötanlage 450 vorgesehen, in der die Prozesstemperaturprofilierung in einer Prozesszone 460 in Abhängigkeit eines gewünschten Temperaturprofils sowie in Abhängigkeit der mittleren Transportgeschwindigkeit des Bandes 401 mittels einer entsprechenden Steuereinrichtung 470 eingestellt wird. Beispielsweise kann die Lötanlage 450 in einer der zuvor dargestellten Ausführungsformen vorgesehen werden. Des Weiteren kann in einer anschaulichen Ausführungsform in der Anlage 450 zusätzlich zu den Wärmeleitoberflächen in der Prozesszone 460 eine oder mehrere unabhängige Wärmequellen bzw. Kühlquellen (nicht gezeigt) vorgesehen sein, um das Band 401 mit einer gewünschten Prozesstemperatur zu beaufschlagen, wobei die eigentliche Profilierung durch die Wärmeleitoberflächen in der Prozesszone 460 bewerkstelligt wird. In anderen Ausführungsformen ist zusätzlich oder alternativ eine Fluidzufuhreinrichtung 490 vorgesehen, die ausgebildet ist, zumindest die in der Prozesszone 460 gerade prozessierten Substratabschnitte mit einem oder mehreren geeigneten Prozessgasen zu beaufschlagen. Beispielsweise kann die Prozesszone 460 mit Stickstoff gespült werden, um damit eine Kontamination oder eine Beeinträchtigung der entstehenden Lötverbindungen zu verringern.

Es sollte beachtet werden, dass die zuvor mit Bezug zu den Figuren 2 und 3 beschriebenen Prozesszonen der Lötanlage auch geeignet kombiniert und insbesondere in Verbindung mit dem System 400 eingesetzt werden können.

## Patentansprüche

1. Verfahren zum Betreiben einer eine ersten Wärmeleitoberfläche (261a, 361a) enthaltenden Reflow-Lötanlage (250) für Substrate (201, 301), umfas-send folgende Schritte:
Steuern der Temperatur der Substrate (201, 301) in einer Prozesszone (260, 360) der Reflow-Lötanlage (250) unter Berücksichtigung eines vorgegebenen Solltemperaturprofils,
wobei das Steuern der Temperatur der Substrate (201, 301) ein Vorgeben der Dauer einer kumulierten Beaufschlagung eines Substrats (201, 301) mit einer ersten Prozesstemperatur (T1) umfasst,
**dadurch gekennzeichnet,**
**dass** die Substrate (201, 301) mit einer Zuführrate zur Bearbeitung zugeführt werden, die durch einen dem Bearbeitungsprozess in der Reflow-Lötanlage (250) vorgeordneten Bearbeitungsprozess festgelegt ist,
**dass** das Steuern der Temperatur der Substrate (201, 301) in einer Prozesszone (260, 360) der Reflow-Lötanlage (250) unter Berücksichtigung der festgelegten Zuführrate erfolgt, wobei die Substrate (201, 301) schrittweise mit einer vorgegebenen Taktrate entsprechend der Zuführrate zugeführt werden; und
**dass** das Substrat (201, 301) während des Taktes mit der ersten Wärmeleitoberfläche (261a, 361 a) in Kontakt gebracht wird.

2. Verfahren nach Anspruch 1, wobei das Steuern der Temperatur der Substrate (201, 301) ferner umfasst: Einstellen der kumulierten Beaufschlagung des Substrats (201, 301) mit einer zweiten, von der ersten Prozesstemperatur (T1) verschiedenen Prozesstemperatur (T2).

3. Verfahren nach Anspruch 1, wobei eine zweite Wärmeleitoberfläche (261b, 361 b) mit dem Substrat (201) in Kontakt gebracht wird und die zweite Wärmeleitoberfläche (261b, 361 b) eine Oberflächentemperatur aufweist, die sich von der Oberflächentemperatur der ersten Wärmeleitoberfläche (261a) unterscheidet.

4. Verfahren nach Anspruch 3, wobei die erste und die zweite Wärmeleitoberfläche (261a, 261b) zeitlich sequentiell mit dem Substrat (201) durch eine Verschiebung parallel zu einer durch das Substrat (201) definierten Ebene in Kontakt gebracht werden, oder durch eine Verschiebung im Wesentlichen senkrecht zu einer durch das Substrat (201) definierten Ebene in Kontakt gebracht werden.

5. Verfahren nach einem der Ansprüche 1 bis 4, wobei die Prozesszone (260) eine Heizfläche (262a, 263a) aufweist, deren effektive Größe einer Größe der auf den Substraten (201) aufgebrachten Schaltungen angepasst wird,
wobei die effektive Größe der Heizfläche (262a, 263a) durch Austauschen einer ersten Heizfläche (262a) mit einer ersten Größe durch eine zweite Heizfläche (263a) mit einer zweiten Größe angepasst wird oder
wobei die effektive Größe der Heizfläche durch Einstellen einer Sollprozesstemperatur in ausgewählten Abschnitten der Heizfläche angepasst wird.

6. Verfahren nach einem der Ansprüche 1 bis 5, wobei die Prozesszone (260) eine Kühlfläche (262b, 263b) aufweist, deren effektive Größe einer Größe der auf den Substraten (201) aufgebrachten Schaltungen angepasst wird,
wobei die effektive Größe der Kühlfläche (262b, 263b) durch Austauschen einer ersten Kühlfläche (262b) mit einer ersten Größe durch eine zweite Kühlfläche (263b) mit einer zweiten Größe angepasst wird, oder
wobei die effektive Größe der Kühlfläche (262b, 263b) durch Einstellen einer Sollprozesstemperatur in ausgewählten Abschnitten der Kühlfläche (262b, 263b) angepasst wird.

7. Verfahren nach Anspruch 1, wobei die Substrate (201) in der Prozesszone (260) mit einer Wärmequelle und/oder einer Wärmesenke unabhängig von der Wärmeleitoberfläche gekoppelt werden, um die Temperatur der Substrate (201) zu steuern.

8. Reflow-Lötanlage (250) zur Durchführung des Verfahrens gemäß einem der Ansprüche 1 - 7, mit:
einer Steuereinrichtung (270, 470); und
einer Prozesszone (260) mit einem in Transportrichtung von Substraten (201, 301) unter Verwendung einer oder mehrerer Wärmeleitoberflächen (261 a, 261 b) erzeugbaren Prozesstemperaturprofil, das während der Bearbeitung der Substrate (201, 301) zum Vorgeben eines gewünschten Temperaturverlaufs in den Substraten (201, 301) veränderbar ist, wobei die Prozesszone (260, 360) eine erste Wärmeleitoberfläche (261 a, 361 a) aufweist, die während des Betriebs bei Ruhelage des Substrats (201, 301) zeitgesteuert mit diesem koppelbar und entkoppelbar ist,
**dadurch gekennzeichnet,**
**dass** die Steuereinrichtung (270, 470)so ausgelegt ist, dass die Substrate (201, 301) mit einer Zuführrate zur Bearbeitung zugeführt werden, die durch einen dem Bearbeitungsprozess in der Reflow-Lötanlage (250) vorgeordneten Bearbeitungsprozess festgelegt ist, wobei die Substrate (201, 301) schrittweise mit einer vorgegebenen Taktrate entsprechend der festgelegten Zuführrate zugeführt werden, und
**dass** die Steuereinrichtung (270, 470) so ausgelegt ist, dass das Steuern der Temperatur der Substrate (201, 301) in der Prozesszone (260, 360) der Reflow-Lötanlage (250) unter Berücksichtigung der festgelegten Zuführrate erfolgt.

9. Reflow-Lötanlage (250) nach Anspruch 8, wobei die Prozesszone (260) in getakteter Weise mit einem Substratband (301) beschickbar ist und mindestens ein Substratabschnitt (201 b) des Bandes zwischen zwei aufeinander folgenden Transportaktivitäten zum Befördern des Bandes mit einer ersten Prozesstemperatur (T1) und einer zweiten verschiedenen Prozesstemperatur (T2) beaufschlagbar ist.

10. Reflow-Lötanlage (250) nach einem der Ansprüche 8 und 9, die ferner eine von der Wärmeleitoberfläche (261 a, 261 b) unabhängige Wärmequelle und/oder Wärmesenke aufweist.

11. Reflow-Lötanlage (250) nach einem der Ansprüche 8 bis 10, wobei die Wärmeleitoberfläche (361) mindestens einen Abschnitt (361a, ... 361 n) aufweist, der während des Kontakts mit einem Substrat (301) mit zwei verschiedenen Prozesstemperaturen (T1, ... Tn) betreibbar ist.

12. Reflow-Lötanlage (250) nach Anspruch 11, die ferner eine Schalteinrichtung (367) aufweist, die ausgebildet ist, den Abschnitt (361a) zeitlich aufeinanderfolgend auf eine erste Prozesstemperatur (T1) und eine zweite Prozesstemperatur (T2) zu steuern.

13. Reflow-Lötanlage (250) nach Anspruch 12, wobei mehrere Abschnitte (361a, ... 361 n) vorgesehen sind und die Schalteinrichtung (367) ferner ausgebildet ist, zumindest einige erste Abschnitte auf eine erste Prozesstemperatur (T1) und einige zweite Abschnitte auf eine zweite Prozesstemperatur (T2) zu steuern, um die wirksame Länge der Prozesszone (360) in Bezug auf die erste und zweite Prozesstemperatur (T1, T2) einzustellen.

14. System (400) zur Herstellung von gedruckten Schaltungen auf einem kontinuierlichen Substratmaterial (401), wobei das System (400) umfasst:
eine Druckeinrichtung (410) zur Aufdrucken eines Lotmaterials auf einen Bereich mit vorgegebener Größe des Substratmaterials,
eine Bestückungseinrichtung (420) zum Aufbringen von Komponenten auf jeden Bereich mit vorgegebener Größe,
eine Transporteinrichtung (402) zum Transportieren des kontinuierlichen Substratmaterials (401), und
eine Reflow-Lötanlage (450) gemäß einem der Ansprüche 8 bis 13.

15. System (400) nach Anspruch 14, wobei die mittlere Transportgeschwindigkeit durch die Bestückungseinrichtung (420) vorgegeben ist.

## Claims

1. Method for operating a reflow soldering system (250) for substrates (201, 301) containing a first heat conduction surface (261a, 361a), comprising the following steps:
controlling the temperature of the substrates (201, 301) in a process zone (260, 360) of the reflow soldering system (250) while taking a predetermined setpoint temperature profile into account,
the control of the temperature of the substrates (201, 301) comprising specification of the duration of cumulative exposure of a substrate (201, 301) to a first process temperature (T1), **characterised in that**
the substrates (201, 301) are fed to the treatment with a feed rate which is established by a treatment process upstream of the treatment process in the reflow soldering system (250),
**in that** the control of the temperature of the substrates (201, 301) in a process zone (260, 360) of the reflow soldering system (250) is carried out while taking the established feed rate into account, the substrates (201, 301) being fed stepwise with a predetermined cycle rate according to the feed rate; and
**in that** the substrate (201, 301) is brought in contact with the first heat conduction surface (261a, 361a) during the cycle.

2. Method according to Claim 1, wherein the control of the temperature of the substrates (201, 301) furthermore comprises: adjustment of the cumulative exposure of the substrate (201, 301) to a second process temperature (T2) different from the first process temperature (T1).

3. Method according to Claim 1, wherein a second heat conduction surface (261b, 361b) is brought in contact with the substrate (201) and the second heat conduction surface (261b, 361b) has a surface temperature which differs from the surface temperature of the first heat conduction surface (261 a).

4. Method according to Claim 3, wherein the first and second heat conduction surfaces (261a, 261b) are brought chronologically sequentially in contact with the substrate (201) by a displacement parallel to a plane defined by the substrate (201), or are brought in contact by a displacement essentially perpendicular to a plane defined by the substrate (201).

5. Method according to one of Claims 1 to 4, wherein the process zone (260) has a heating surface (262a, 263a), the effective size of which is adapted to a size of the circuits applied onto the substrates (201),
the effective size of the heating surface (262a, 263a) being adapted by replacing a first heating surface (262a) of a first size with a second heating surface (263a) of a second size, or
the effective size of the heating surface being adapted by adjusting a setpoint process temperature in selected sections of the heating surface.

6. Method according to one of Claims 1 to 5, wherein the process zone (260) has a cooling surface (262b, 263b), the effective size of which is adapted to a size of the circuits applied onto the substrates (201),
the effective size of the cooling surface (262b, 263b) being adapted by replacing a first cooling surface (262b) of a first size with a second cooling surface (263b) of a second size, or
the effective size of the cooling surface (262b, 263b) being adapted by adjusting a setpoint process temperature in selected sections of the cooling surface (262b, 263b).

7. Method according to Claim 1, wherein the substrates (201) are coupled in the process zone (260) to a heat source and/or a heat sink, independently of the heat conduction surface, in order to control the temperature of the substrates (201).

8. Reflow soldering system (250) for carrying out the method according to one of Claims 1 - 7, having: a control device (270, 470); and
a process zone (260, 360) having a process temperature profile, generated by using one or more heat conduction surfaces (261a, 261b), which can be modified during the treatment of the substrates (201, 301) in order to specify a desired temperature profile in the substrates (201, 301), the process zone (260) having a first heat conduction surface (261 a, 361 a) which, during operation, can be coupled to and decoupled from the substrate (201, 301) with control as a function of time while the latter is stationary, **characterised in that** the control device (270, 470) is configured in such a way that the substrates (201, 301) are fed to the treatment with a feed rate which is established by a treatment process upstream of the treatment process in the reflow soldering system (250), the substrates (201, 301) being fed stepwise with a predetermined cycle rate according to the established feed rate, and
**in that** the control device (270, 470) is configured in such a way that the control of the temperature of the substrates (201, 301) in the process zone (260, 360) of the reflow soldering system (250) is carried out while taking the established feed rate into account.

9. Reflow soldering system (250) according to Claim 8, wherein the process zone (260) can receive a substrate strip (301) in a cycled fashion, and at least one substrate section (201b) of the strip can be exposed to a first process temperature (T1) and a different second process temperature (T2) between two successive transport activities for conveying the strip.

10. Reflow soldering system (250) according to one of Claims 8 and 9, which furthermore comprises a heat source and/or a heat sink independent of the heat conduction surface (261 a, 261 b).

11. Reflow soldering system (250) according to one of Claims 8 to 10, wherein the heat conduction surface (361) has at least one section (361a, ... 361 n) which can be operated with at least two different process temperatures (T1, ... Tn) during the contact with a substrate (301).

12. Reflow soldering system (250) according to Claim 11, which furthermore comprises a switching device (367) which is configured in order to control the section (361 a) chronologically in succession to a first process temperature (T1) and a second process temperature (T2).

13. Reflow soldering system (250) according to Claim 12, wherein a plurality of sections (361 a, ... 361 n) are provided, and the switching device (367) is furthermore configured in order to control at least some first sections to a first process temperature (T1) and at least some second sections to a second process temperature (T2), in order to adjust the effective length of the process zone (360) in relation to the first and second process temperatures (T1, T2).

14. System (400) for producing printed circuits on a continuous substrate material (401), the system comprising:
a printing device (410) for printing a solder material onto a region of the substrate with a predetermined size, an applicator device (420) for applying components onto each region with a predetermined size,
a transport device (402) for transporting the continuous substrate material (401), and a reflow soldering system (450) according to one of Claims 8 to 13.

15. System (400) according to Claim 14, wherein the average transport speed is specified by the applicator device (420).

## Revendications

1. Procédé pour faire fonctionner une installation de brasage ou soudage par refusion (250) pour des substrats (201, 301), qui comporte une première surface de conduction de chaleur (261a, 361a), le procédé comprenant les étapes suivantes :
commande de la température des substrats (201, 301) dans une zone d'exécution de processus (260, 360) de l'installation de soudage par refusion (250), en tenant compte d'un profil de température de consigne prescrit,
la commande de la température des substrats (201, 301) englobant la prescription de la durée d'une sollicitation cumulée d'un substrat (201, 301) avec une première température de processus (T1),
**caractérisé**
**en ce que** les substrats (201, 301) sont amenés au traitement avec une cadence d'amenée déterminée par un processus de traitement, qui précède le processus de traitement dans l'installation de soudage par refusion (250),
**en ce que** la commande de la température des substrats (201, 301) s'effectue dans une zone d'exécution de processus (260, 360) de l'installation de soudage par refusion (250) en prenant en considération la cadence d'amenée déterminée, les substrats (201, 301) étant amenés pas à pas avec une cadence de cycle prescrite correspondant à la cadence d'amenée ; et
**en ce que** le substrat (201, 301) est amené en contact avec la première surface de conduction de chaleur (261a, 361a) pendant le cycle.

2. Procédé selon la revendication 1, d'après lequel la commande de la température des substrats (201, 301) comprend, en outre : le réglage de la sollicitation cumulée du substrat (201, 301) avec une deuxième température de processus (T2) différente de la première température de processus (T1).

3. Procédé selon la revendication 1, d'après lequel une deuxième surface de conduction de chaleur (261b, 361b) est amenée en contact avec le substrat (201), et la deuxième surface de conduction de chaleur (261b, 361b) présente une température de surface qui se différencie de la température de surface de la première surface de conduction de chaleur (261a).

4. Procédé selon la revendication 3, d'après lequel la première et la deuxième surface de conduction de chaleur (261a, 261b) sont amenées en contact, séquentiellement dans le temps, avec le substrat (201), par un coulissement parallèlement à un plan défini par le substrat (201), ou par un coulissement sensiblement de manière perpendiculaire à un plan défini par le substrat (201).

5. Procédé selon l'une des revendications 1 à 4, d'après lequel la zone d'exécution de processus (260) présente une surface de chauffage (262a, 263a), dont on adapte la grandeur effective à une grandeur des circuits appliqués sur les substrats (201),
l'adaptation de la grandeur effective de la surface de chauffage (262a, 263a) se faisant par le remplacement d'une première surface de chauffage (262a) d'une première grandeur, par une deuxième surface de chauffage (263a) d'une deuxième grandeur, ou
l'adaptation de la grandeur effective de la surface de chauffage se faisant par réglage d'une température de processus de consigne dans des secteurs sélectionnés de la surface de chauffage.

6. Procédé selon l'une des revendications 1 à 5, d'après lequel la zone d'exécution de processus (260) présente une surface de refroidissement (262b, 263b) dont on adapte la grandeur effective à une grandeur des circuits appliqués sur les substrats (201), l'adaptation de la grandeur effective de la surface de refroidissement (262b, 263b) se faisant par le remplacement d'une première surface de refroidissement (262b) d'une première grandeur, par une deuxième surface de refroidissement (263b) d'une deuxième grandeur, ou l'adaptation de la grandeur effective de la surface de refroidissement (262b, 263b) se faisant par réglage d'une température de processus de consigne dans des secteurs sélectionnés de la surface de refroidissement (262b, 263b).

7. Procédé selon la revendication 1, d'après lequel les substrats (201) sont, dans la zone d'exécution de processus (260), couplés à une source de chaleur et/ou à un dissipateur thermique indépendamment de la surface de conduction de chaleur, en vue de commander la température des substrats (201).

8. Installation de brasage ou soudage par refusion (250) pour la mise en oeuvre du procédé selon l'une des revendications 1 - 7, comprenant
un dispositif de commande (270, 470) ; et
une zone d'exécution de processus (260) avec un profil de température de processus, qui peut être engendré dans la direction de transport de substrats (201, 301) en utilisant une ou plusieurs surfaces de conduction de chaleur (261a, 261b), et qui peut être modifié pendant le traitement des substrats (201, 301) pour prescrire une loi de variation de température souhaitée dans les substrats (201, 301), la zone d'exécution de processus (260), 360) présentant une première surface de conduction de chaleur (261a, 361a), qui, pendant le fonctionnement et en position de repos du substrat (201, 301), peut être couplée à celui-ci et découplée de celui-ci de manière commandée dans le temps,
**caractérisé**
**en ce que** le dispositif de commande (270, 470) est conçu de manière à ce que les substrats (201, 301) soient amenés au traitement avec une cadence d'amenée déterminée par un processus de traitement qui précède le processus de traitement dans l'installation de soudage par refusion (250), les substrats (201, 301) étant amenés pas à pas avec une cadence de cycle prescrite correspondant à la cadence d'amenée déterminée, et
**en ce que** le dispositif de commande (270, 470) est conçu de manière à ce que la commande de la température des substrats (201, 301) s'effectue dans la zone d'exécution de processus (260, 360) de l'installation de soudage par refusion (250), en prenant en considération la cadence d'amenée déterminée.

9. Installation de soudage par refusion (250) selon la revendication 8, dans laquelle la zone d'exécution de processus (260) peut être alimentée de manière cyclique avec une bande de substrat (301), et au moins un secteur de substrat (201b) de la bande peut, entre deux activités de transport pour transporter la bande, être sollicité par une première température de processus (T1) et une deuxième température de processus (T2) différente.

10. Installation de soudage par refusion (250) selon l'une des revendications 8 et 9, qui comprend par ailleurs une source de chaleur et/ou un dissipateur thermique indépendant de la surface de conduction de chaleur (261a, 261b).

11. Installation de soudage par refusion (250) selon l'une des revendications 8 à 10, dans laquelle la surface de conduction de chaleur (361) présente au moins un secteur (361a, ... 361n), qui pendant le contact avec un substrat (301) peut fonctionner avec deux températures de processus (T1, ... Tn) différentes.

12. Installation de soudage par refusion (250) selon la revendication 11, comprenant, par ailleurs, un dispositif de commutation (367), qui est conçu pour assurer une commande permettant d'amener le secteur (361a) successivement dans le temps, à une première température de processus (T1) et une deuxième température de processus (T2).

13. Installation de soudage par refusion (250) selon la revendication 12, dans laquelle sont prévus plusieurs secteurs (361a, ... 361n), et le dispositif de commutation (367) est par ailleurs conçu pour assurer une commande permettant d'amener au moins quelques premiers secteurs à une première température de processus (T1), et quelques deuxièmes secteurs à une deuxième température de processus (T2), en vue de régler la longueur active de la zone d'exécution de processus (360) relativement à la première et la deuxième température de processus (T1, T2).

14. Système (400) pour la fabrication de circuits imprimés sur un matériau de substrat continu (401), le système (400) comprenant :
un dispositif d'impression (410) pour appliquer par impression un matériau de brasage ou soudage sur un secteur de grandeur prédéterminée du matériau de substrat,
un dispositif d'implantation de composants (420) pour la mise en place de composants sur chaque secteur de grandeur prédéterminée,
un dispositif de transport (402) pour transporter le matériau de substrat continu (401), et
une installation de soudage par refusion (450) selon l'une des revendications 8 à 13.

15. Système (400) selon la revendication 14, dans lequel la vitesse de transport moyenne est prescrite par le dispositif d'implantation de composants (420).
